(19) Europäisches Patentamt
European Patent Office
Office européen des brevets

(11) EP 2 124 270 A1

(12) **EUROPEAN PATENT APPLICATION**
published in accordance with Art. 153(4) EPC

(43) Date of publication:
**25.11.2009 Bulletin 2009/48**

(21) Application number: **08711679.4**

(22) Date of filing: **20.02.2008**

(51) Int Cl.:
***H01L 51/50*** *(2006.01)*

(86) International application number:
**PCT/JP2008/052873**

(87) International publication number:
**WO 2008/105294 (04.09.2008 Gazette 2008/36)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **28.02.2007 JP 2007050857**

(71) Applicant: **Idemitsu Kosan Co., Ltd.**
**Chiyoda-ku**
**Tokyo 100-8321 (JP)**

(72) Inventors:
- **KAWAMURA, Hisayuki**
**Sodegaura-shi**
**Chiba 299-0293 (JP)**
- **KUMA, Hitoshi**
**Sodegaura-shi**
**Chiba 299-0293 (JP)**
- **INOUE, Tetsuya**
**Sodegaura-shi**
**Chiba 299-0293 (JP)**

(74) Representative: **Gille Hrabal Struck Neidlein Prop Roos**
**Patentanwälte**
**Brucknerstrasse 20**
**40593 Düsseldorf (DE)**

## (54) ORGANIC EL DEVICE

(57) In an organic electroluminescence device including an anode, a hole injecting layer, an emitting layer, an electron transporting layer and a cathode, the hole injecting layer contains poly(alkylene dioxythophene) and at least one type of fluorine-containing colloid-forming polymer acids. The electron transporting layer contains a nitrogen-containing heterocycle derivative represented by a formula (1) below.

$$HAr\text{-}L\text{-}Ar^1\text{-}Ar^2 \qquad (1)$$

(In the formula: HAr represents a substituted or unsubstituted nitrogen-containing heterocycle group having 3 to 40 carbon atoms; L represents, a single bond, a substituted or unsubstituted arylene group having 6 to 60 carbon atoms, a substituted or unsubstituted heteroarylene group having 3 to 60 carbon atoms, or a substituted or unsubstituted fluorenylene group; $Ar^1$ represents a substituted or unsubstituted divalent aromatic hydrocarbon group having 6 to 60 carbon atoms; and $Ar^2$ represents a substituted or unsubstituted aryl group having 3 to 60 carbon atoms.)

EP 2 124 270 A1

## Description

TECHNICAL FIELD

The present invention relates to an organic electroluminescence device.

BACKGROUND ART

Such an organic electroluminescence as described below has been conventionally known.
An organic electroluminescence device is a self-emitting device that is based on a principle according to which a fluorescent material emits lights by recombination energy caused by holes injected from an anode and electrons injected from cathode.
An organic electroluminescence device is provided by laminating functional layers such as a hole injecting layer, a hole transporting layer, an emitting layer, an electron transporting layer and an electron injecting layer. The emitting layer contains a host material and a dopant material, where an energy transmission or the like is generated from the host material to the dopant material, so that the dopant material shows an emitting function.
As a host material for providing an organic electroluminescence device that is excellent in lifetime, luminous efficiency and the like, an anthracene derivative is known.
According to an exemplary known arrangement of an organic electroluminescence device having a long lifetime and high luminous efficiency, a copper phthalocyanine-based compound is used as the hole injecting layer, an anthracene derivative is used as a host material for the emitting layer and aluminum (Alq) complex is used as the electron transporting layer.
However, such a device arrangement has required a high drive voltage.
Meanwhile, as a hole injecting layer material that is excellent in transporting holes and expected to decrease the drive voltage of the entire organic electroluminescence device, a composition containing polyethylenedioxithiophene (PEDOT) and polystyrene sulfonate (PSS) has been known (e.g., Patent Document 1).
In recent years, there has been an attempt to prolong the lifetime of an organic electroluminescence device by using a composition prepared by adding a perfluorinated polymer to PEDOT as the hole injecting layer (e.g., Patent Documents 2, 3, 4, 5 and 6).
However, the lifetime of such an organic electroluminescence device has been much shorter than the lifetime of a conventional organic electroluminescence device, i.e., shorter than the inherent lifetime of an anthracene derivative.
Patent Document 1: JP-A-2000-091081
Patent Document 2: JP-A-2003-297582
Patent Document 3: JP-A-2005-232452
Patent Document 4: JP-A-2006-500461
Patent Document 5: JP-A-2006-500463
Patent Document 6: JP-A-2006-313931

DISCLOSURE OF THE INVENTION

PROBLEMS TO BE SOLVED BY THE INVENTION

Due to such problems as described above, a low voltage-driven organic electroluminescence device having high luminous efficiency and a long lifetime has been yet to be developed, a realization of which has been demanded.
An object of the present invention is to solve the above problem(s) and to provide an organic electroluminescence device that has high luminous efficiency and a long lifetime, and that can be driven by a low voltage.

MEANS FOR SOLVING THE PROBLEMS

An organic electroluminescence device according to an aspect of the present invention includes an anode, a hole injecting layer, an emitting layer, an electron transporting layer and a cathode in this order, in which the hole injecting layer contains: substituted or unsubstituted poly(alkylene dioxythiophene); and a fluorine-containing colloid-forming polymer acid, and the electron transporting layer contains a compound having electron mobility of $1.0 \times 10^{-4} cm^2/Vs$ or more at an electric field intensity of $2.5 \times 10^5 V/cm$.
According to the aspect of the present invention, the electron transporting layer contains a nitrogen-containing heterocycle derivative represented by a formula (1) as follows.

HAr-L-$Ar^1$-$Ar^2$ (1)

In the above formula (1), HAr represents a substituted or unsubstituted nitrogen-containing heterocycle group having 3 to 40 carbon atoms.
L represents a single bond, a substituted or unsubstituted arylene group having 6 to 60 carbon atoms, a substituted or unsubstituted heteroarylene group having 3 to 60 carbon atoms, or a substituted or unsubstituted fluorenylene group.
$Ar^1$ represents a substituted or unsubstituted divalent aromatic hydrocarbon group having 6 to 60 carbon atoms.
$Ar^2$ represents a substituted or unsubstituted aryl group having 3 to 60 carbon atoms.

With the above-described arrangement, while exhibiting high luminous efficiency and a long lifetime, the organic electroluminescence device can be driven by a low voltage.

According to a conventionally-known arrangement of an organic electroluminescence device having a long lifetime and high luminous efficiency, a copper phthalocyanine-based compound is used as the hole injecting layer while Alq complex is used as the electron transporting layer. However, a problem of such an arrangement has been that the drive voltage is high.
On the other hand, according to a known arrangement of a low voltage-driven organic electroluminescence device having high luminous efficiency, a copper phthalocyanine-based compound is used as the hole injecting layer while a nitrogen-containing heterocycle derivative is used as the electron transporting layer (e.g., WO2004-080975). However, a problem of such an arrangement has been that the lifetime of the organic electroluminescence device is short.
In addition, according to another known arrangement of a low voltage-driven organic electroluminescence device having high luminous efficiency, a material prepared by adding PSS to PEDOT is used as the hole injecting layer while Alq complex is used as the electron transporting layer. However, a problem of such an arrangement has been that an emitting zone of the emitting layer is shifted toward the cathode, by which the luminous efficiency and the lifetime of the organic electroluminescence device are deteriorated.

In recent years, there has been an attempt to prolong the lifetime of an organic electroluminescence device by using a compound prepared by adding a perfluorinated polymer to PEDOT as the hole injecting layer (see, Patent Documents 3, 4, 5 and 6). However, the lifetime of such an organic electroluminescence device has been much shorter than the expected lifetime of an emitting material used in an organic electroluminescence device.
In other words, a low voltage-driven organic electroluminescence device having high luminous efficiency and a long lifetime has been yet to be developed, and it has been predicted that the drive voltage and the lifetime of an organic electroluminescence device are in a tradeoff relationship.

After various studies, the inventors of the present invention have found that an organic electroluminescence device in which a compound prepared by adding a perfluorinated polymer to substituted or unsubstituted poly(alkylene dioxythiophene) is used as the hole injecting layer while a nitrogen-containing heterocycle derivative is used as the electron transporting layer can be driven by a low voltage while exhibiting high luminous efficiency and a long lifetime.
When substituted or unsubstituted poly(alkylene dioxythiophene) is used as the hole injecting layer, the emitting zone of the emitting layer tends to be shifted toward the cathode due to high hole mobility in the hole injecting layer. In general, the emitting zone is preferably located adjacent to the anode in the emitting layer. It is considered that the luminous efficiency and the lifetime of the organic electroluminescence device are deteriorated when the emitting zone is located adjacent to the cathode therein.
The inventors have found that holes and electrons can be injected in a balanced manner by using a nitrogen-containing heterocycle derivative that exhibits high charge mobility for forming the electron transporting layer, and that the lifetime of an organic electroluminescence can be prolonged while high luminous efficiency and low-voltage drivability obtained by using poly(alkylene dioxythiophene) as the hole injecting layer are retained, and have reached the present invention.

Electron mobility of the electron transporting material is preferably $1.0 \times 10^{-4}$ $cm^2/Vs$, an exemplary upper limit of which is set around $1.0 \times 10^{-2}$.

According to the aspect of the present invention, it is preferable that the emitting layer contains a host and a dopant, and the host is formed of a material having a molecular weight of 4000 or less.
With the above arrangement, not only the combination of the hole transporting layer and the electron transporting layer but also characteristics of the emitting layer can contribute to a longer lifetime and higher luminous efficiency of the organic electroluminescence device. Accordingly, performance of the organic electroluminescence device can be further enhanced.

According to the aspect of the present invention, it is preferable that the host contains a fused-ring compound having at least three rings.
With the above arrangement, characteristics of the host can contribute to a longer lifetime and higher luminous efficiency of the device, thereby further enhancing performance of the organic electroluminescence device.

According to the aspect of the present invention, it is preferable that the fused-ring compound having at least three rings is an anthracene derivative.

An anthracene derivative is known as a host material that is excellent in the lifetime, the luminous efficiency and the like. By using an anthracene derivative, the lifetime of the device can be further prolonged while the luminous efficiency of the device can be enhanced, thereby further enhancing performance of the organic electroluminescence device.

According to the aspect of the present invention, it is preferable that the anthracene derivative is represented by a formula (2) as follows.

[Formula 1]

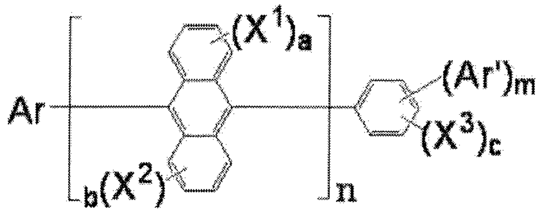

(2)

In the above formula (2), Ar represents a substituted or unsubstituted fused aromatic group having 10 to 50 carbon atoms forming the aromatic ring.

Ar' represents a substituted or unsubstituted aromatic group having 6 to 50 carbon atoms forming the aromatic ring.

$X^1$ to $X^3$ each represent a substituted or unsubstituted aromatic group having 6 to 50 carbon atoms forming the aromatic ring, a substituted or unsubstituted aromatic heterocyclic group having 5 to 50 carbon atoms forming the aromatic ring, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 carbon atoms, a substituted or unsubstituted arylthio group having 5 to 50 carbon atoms, a substituted or unsubstituted alkoxycarbonyl group having 1 to 50 carbon atoms, a carboxyl group, a halogen group, a cyano group, a nitro group and a hydroxyl group.

a, b and c are each an integer in a range of 0 to 4. A plurality of $X^1$ may be mutually the same or different when a is 2 or more. A plurality of $X^2$ may be mutually the same or different when b is 2 or more. A plurality of $X^3$ may be mutually the same or different when c is 2 or more.

n is an integer in a range of 1 to 3 while m is 0 or 1, a plurality of such structures shown in the brackets [ ] as represented by a formula below being mutually the same or different when n is 2 or more.

[Formula 2]

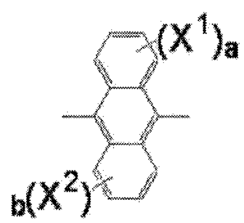

According to the above arrangement, since a compound having an asymmetry specific structure represented by the above formula (2) is used as the host, the luminous efficiency of the organic electroluminescence device can be further enhanced while the lifetime of the device can be further prolonged.

According to the aspect of the present invention, it is preferable that the anthracene derivative is an asymmetric monoanthracene derivative represented by a formula (3) as follows.

[Formula 3]

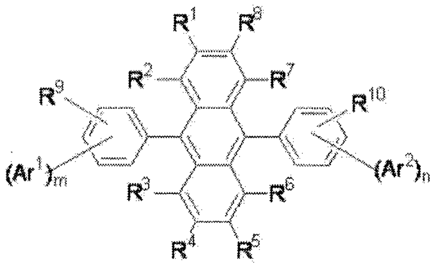

(3)

In the above formula (3), $Ar^1$ and $Ar^2$ are each a substituted or unsubstituted aromatic ring group having 6 to 50 carbon atoms forming the aromatic ring while m and n are each an integer in a range of 1 to 4. $Ar^1$ and $Ar^2$ are mutually different when: m and n are both equal to 1; and positions at which $Ar^1$ and $Ar^2$ are respectively bonded to benzene rings are symmetric. m and n are mutually different when m or n is an integer in a range of 2 to 4.
$R^1$ to $R^{10}$ are each a hydrogen atom, a substituted or unsubstituted aromatic ring group having 6 to 50 carbon atoms forming the aromatic ring, a substituted or unsubstituted aromatic heterocycle group having 5 to 50 atoms forming the aromatic ring, a substituted or unsubstituted alkyl group having 1 to 50 carbon atoms, a substituted or unsubstituted cycloalkyl group, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 atoms forming the aromatic ring, a substituted or unsubstituted arylthio group having 5 to 50 atoms forming the aromatic ring, a substituted or unsubstituted alkoxycarbonyl group having 1 to 50 carbon atoms, substituted or unsubstituted silyl group, a carboxyl group, a halogen atom, a cyano group, a nitro group and a hydroxy group.
According to the aspect of the present invention, it is preferable that the anthracene derivative is represented by a formula (4) as follows.
[Formula 4]

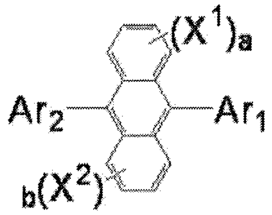

(4)

In the above formula (4), at least either one of $Ar^1$ and $Ar^2$ is a substituent having a substituted or unsubstituted fused ring group with 10 to 30 carbon atoms forming the aromatic ring.
$X^1$ and $X^2$ are each a substituted or unsubstituted aromatic group having 6 to 50 carbon atoms forming the aromatic ring, a substituted or unsubstituted aromatic heterocycle group having 5 to 50 carbon atoms forming the aromatic ring, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 carbon atoms, a substituted or unsubstituted arylthio group having 5 to 50 carbon atoms, a substituted or unsubstituted alkoxycarbonyl group having 1 to 50 carbon atoms, a carboxyl group, a halogen group, a cyano group, a nitro group and hydroxyl group.
a and b are each an integer in a range of 0 to 4. A plurality of $X^1$ may be mutually the same or different when a is 2 or more. A plurality of $X^2$ may be mutually the same or different when b is 2 or more.
According to the aspect of the present invention, it is preferable that the substituted or unsubstituted poly (alkylene dioxythiophene) is poly(3,4-ethylenedioxithiophene).
According to the aspect of the present invention, it is preferable that the fluorine-containing colloid-forming

polymer acid is selected from a group consisting of a fluorine-containing polymer sulfonic acid, a fluorine-containing polymer carboxylic acid, a fluorine-containing polymer phosphoric acid, a fluorine-containing polymer acrylic acid and a mixture of the acids.
By adding such fluorine-containing colloid-forming polymer acid(s) to substituted or unsubstituted poly(alkylene dioxythiophene) in the hole transporting layer, the lifetime of the organic electroluminescence device is expected to be prolonged. With this arrangement, the lifetime of the organic electroluminescence device can be further prolonged.
According to the aspect of the present invention, it is preferable that the fluorine-containing colloid-forming polymer acid is a perfluorinated polymer sulfonic acid.
By adding a perfluorinated polymer to substituted or unsubstituted poly(alkylene dioxythiophene) in the hole transporting layer, the lifetime of the organic electroluminescence device can be prolonged.

BEST MODE FOR CARRYING OUT THE INVENTION

Embodiment(s) of the present invention will be described.

(Arrangement of Organic Electroluminescence Device)

An arrangement of an organic electroluminescence device will be described below.

(1) Arrangement of Organic Electroluminescence Device

Typical arrangement of the organic electroluminescence device may be exemplified by the following arrangements:

(a) anode / emitting layer / cathode;
(b) anode / hole injecting layer / emitting layer / cathode;
(c) anode / emitting layer / electron injecting layer / cathode;
(d) anode / hole injecting layer / emitting layer / electron injecting layer / cathode;
(e) anode / organic semiconductor layer / emitting layer / cathode;
(f) anode / organic semiconductor layer / electron blocking layer / emitting layer / cathode;
(g) anode / organic semiconductor layer / emitting layer / adhesion improving layer/ cathode;
(h) anode / hole injecting layer / hole transporting layer / emitting layer / electron injecting layer / cathode;
(i) anode / insulating layer / emitting layer / insulating layer / cathode;
(j) anode / inorganic semiconductor layer / insulating layer / emitting layer / insulating layer / cathode;
(k) anode / organic semiconductor layer / insulating layer / emitting layer / insulating layer / cathode;
(l) anode / insulating layer / hole injecting layer / hole transporting layer / emitting layer / insulating layer / cathode; and
(m) anode / insulating layer / hole injecting layer / hole transporting layer / emitting layer / electron injecting layer / cathode.

The organic electroluminescence device according to the present embodiment at least includes an anode, an emitting layer, an electron transporting layer and a cathode in this order.

(2) Light-Transmissive Substrate

The organic electroluminescence device is formed on a light-transmissive substrate. The light-transmissive plate, which supports the organic electroluminescence device, is preferably a smoothly-shaped substrate that transmits 50% or more of light in a visible region of 400nm to 700nm.
The light-transmissive plate is exemplarily a glass plate, a polymer plate or the like.
For the glass plate, such materials as soda-lime glass, barium/strontium-containing glass, lead glass, aluminosilicate glass, borosilicate glass, barium borosilicate glass, quartz and the like can be used.
For the polymer plate, such materials as polycarbonate, acryl, polyethylene terephthalate, polyether sulfide, polysulfone and the like can be used.

(3) Anode

The anode of the organic electroluminescence device is used for injecting holes into the hole transporting layer or the emitting layer. It is effective that the anode includes a work function of 4.5 eV or more. Exemplary materials for the anode are indium-tin oxide (ITO), tin oxide (NESA), indium zinc oxide (IZO), gold, silver, platinum and copper. In

order to inject electrons into the electron transporting layer or the emitting layer, materials having smaller work function is more preferably used for the anode.
The anode may be made by forming a thin film from these electrode materials through methods such as vapor deposition and sputtering.
When light emission from the emitting layer is provided through the anode, the anode preferably transmits more than 10% of the emitted light. Sheet resistance of the anode is preferably several hundreds Ω/ square or lower. Although depending on the material of the anode, thickness of the anode is typically in a range from 10 nm to 1 μm, and preferably in a range from 10 to 200 nm.

(4) Emitting Layer

The emitting layer of the organic electroluminescence device has functions described below.
The emitting layer specifically performs: an injecting function for allowing the holes to be injected thereinto from the anode or the hole injecting layer and allowing the electrons to be injected thereinto from the cathode or the electron injecting layer when electric field is impressed; a transporting function for transporting injected charge (the electrons and the holes) by a force of electric field; and an emitting function for providing conditions for recombination of the electrons and the holes for light emission.
Although injectability of the holes may differ from that of the electrons and transporting capabilities of the hole and the electrons (represented by mobilities of the holes and the electrons) may differ from each other, the emitting layer preferably transports either one of the electric charges.
As a method of forming the emitting layer, known methods such as vapor deposition, spin coating and an LB method may be employed.
The emitting layer is preferably a molecular deposit film.
The molecular deposit film means a thin film formed by depositing a material compound in gas phase or a film formed by solidifying a material compound in a solution state or in liquid phase. The molecular deposit film is generally different from a thin film formed by the LB method (molecular accumulation film) in aggregation structures, higher order structures and functional differences arising therefrom.
As disclosed in JP-A-57-51781, the emitting layer can be formed by preparing a solution by dissolving a binder (e.g. a resin) and the material compound in a solvent and forming a thin film from the solution by spin coating or the like.
The thickness of the emitting layer is preferably in the range from 5 to 50 nm, more preferably in the range from 7 to 50 nm and most preferably in the range 10 to 50 nm. The thickness below 5 nm may cause difficulty in forming the emitting layer and in controlling chromaticity, while the thickness above 50 nm may increase driving voltage.
In the organic electroluminescence device according to the present embodiment, the emitting layer contains a host and a dopant.
The host, which is formed of a material having a molecular weight of 4000 or less, contains a fused-ring compound having at least three rings. The fused-ring compound having at least three rings is an anthracene derivative represented by a formula (2) as follows.
[Formula 5]

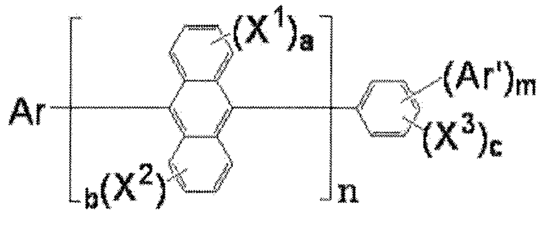

(2)

In the above formula (2); Ar represents a substituted or unsubstituted fused aromatic group having 10 to 50 carbon atoms forming the aromatic ring;
Ar' represents a substituted or unsubstituted aromatic group having 6 to 50 carbon atoms forming the aromatic ring;
$X^1$ to $X^3$ each represent a substituted or unsubstituted aromatic group having 6 to 50 carbon atoms forming the aromatic ring, a substituted or unsubstituted aromatic heterocyclic group having 5 to 50 carbon atoms forming the aromatic ring,

a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 carbon atoms, a substituted or unsubstituted arylthio group having 5 to 50 carbon atoms, a substituted or unsubstituted alkoxycarbonyl group having 1 to 50 carbon atoms, a carboxyl group, a halogen group, a cyano group, a nitro group and a hydroxyl group;
a, b and c are each an integer in a range of 0 to 4, a plurality of $X^1$ being mutually the same or different when a is 2 or more, a plurality of $X^2$ being mutually the same or different when b is 2 or more, a plurality of $X^3$ being mutually the same or different when c is 2 or more; and
n is an integer in a range of 1 to 3 while m is 0 or 1, a plurality of such structures shown in the brackets [ ] as represented by a formula below being mutually the same or different when n is 2 or more.
[Formula 6]

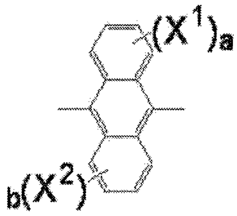

Examples of such an anthracene derivative are as follows.
[Formula 7]

AN1

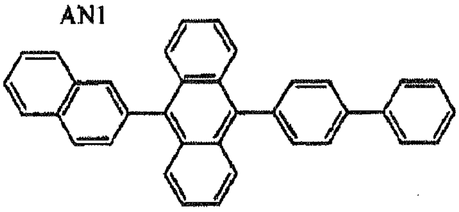

AN2

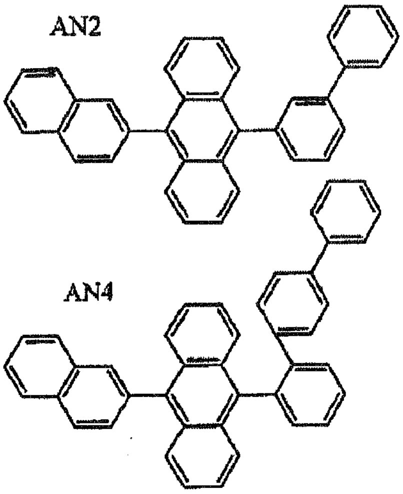

AN3

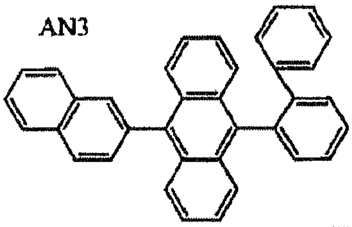

AN4

AN5

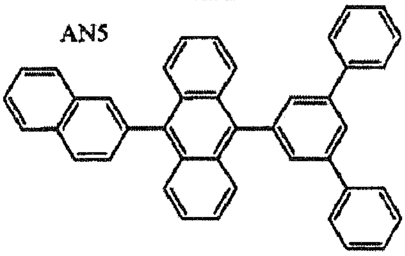

AN6

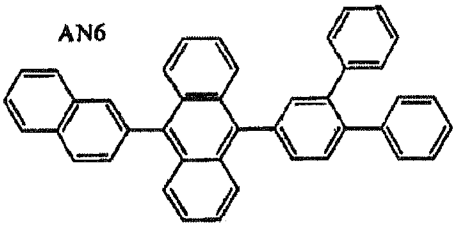

AN7

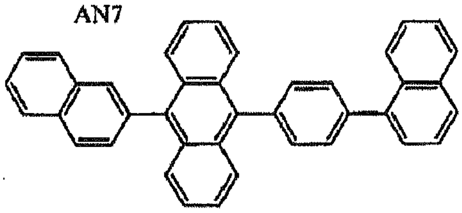

AN8

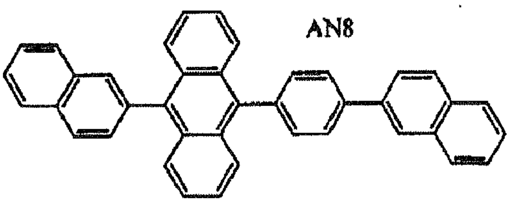

AN9

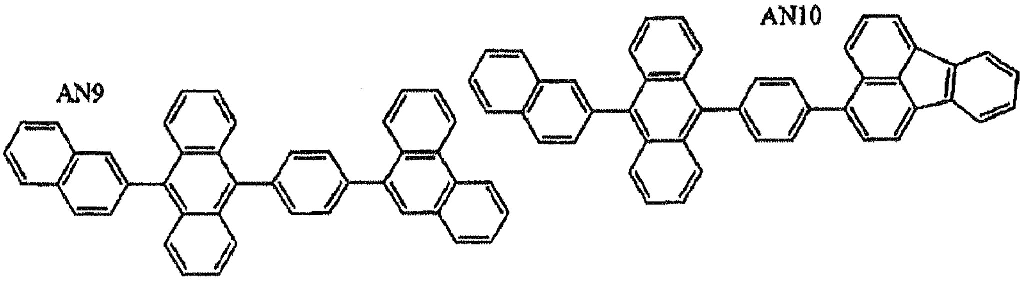

AN10

[Formula 8]

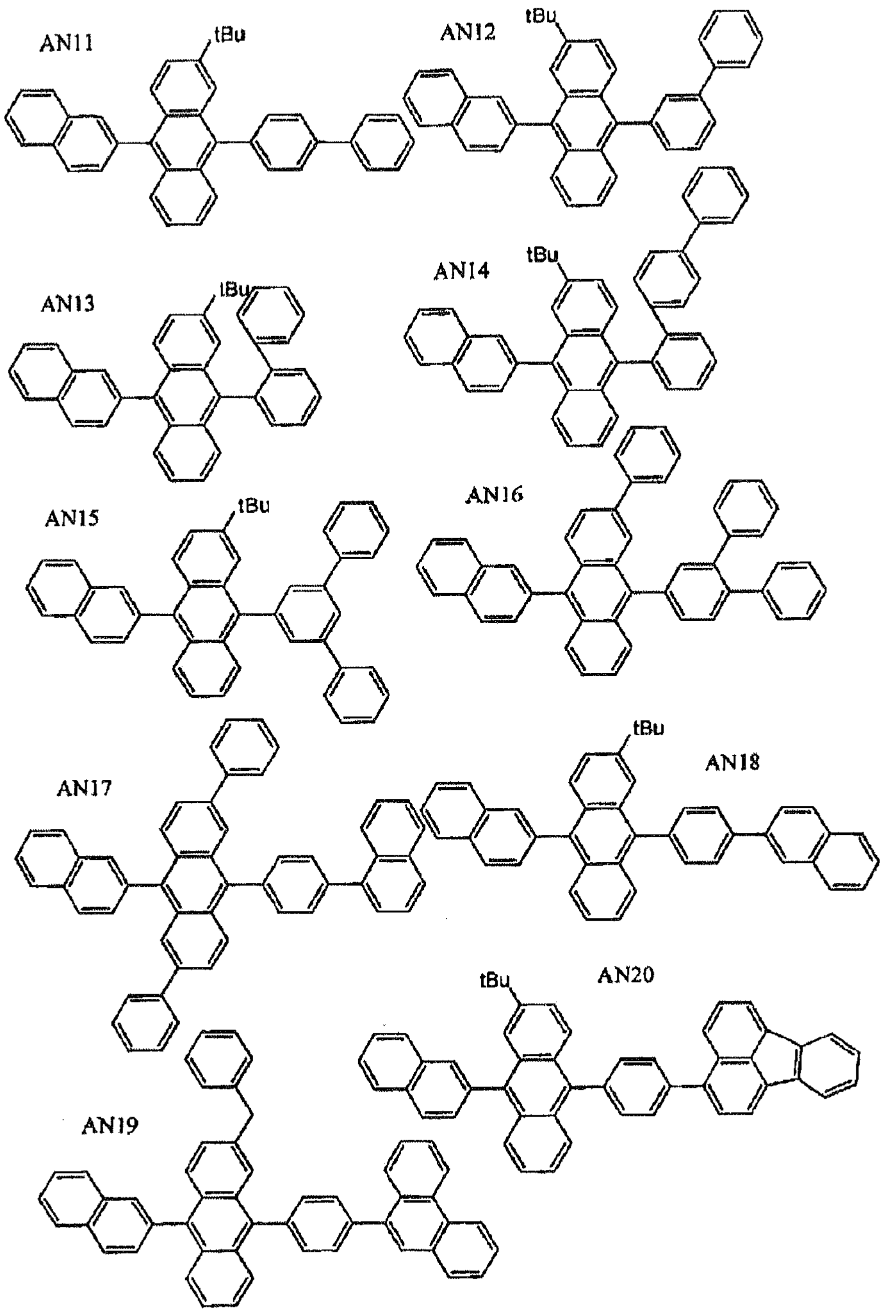

AN11 AN12 AN13 AN14 AN15 AN16 AN17 AN18 AN19 AN20

[Formula 9]

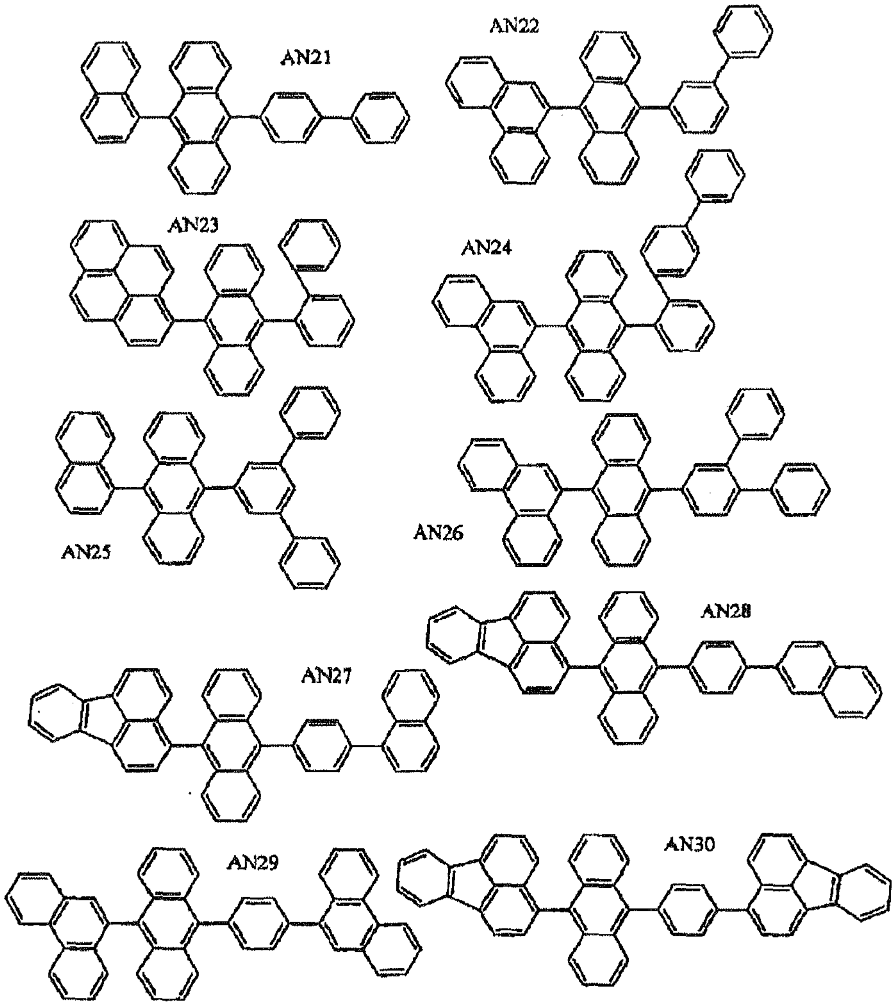

AN21 AN22 AN23 AN24 AN25 AN26 AN27 AN28 AN29 AN30

[Formula 10]

AN31 AN32 AN33 AN34 AN35 AN36 AN37 AN38 AN39 AN40

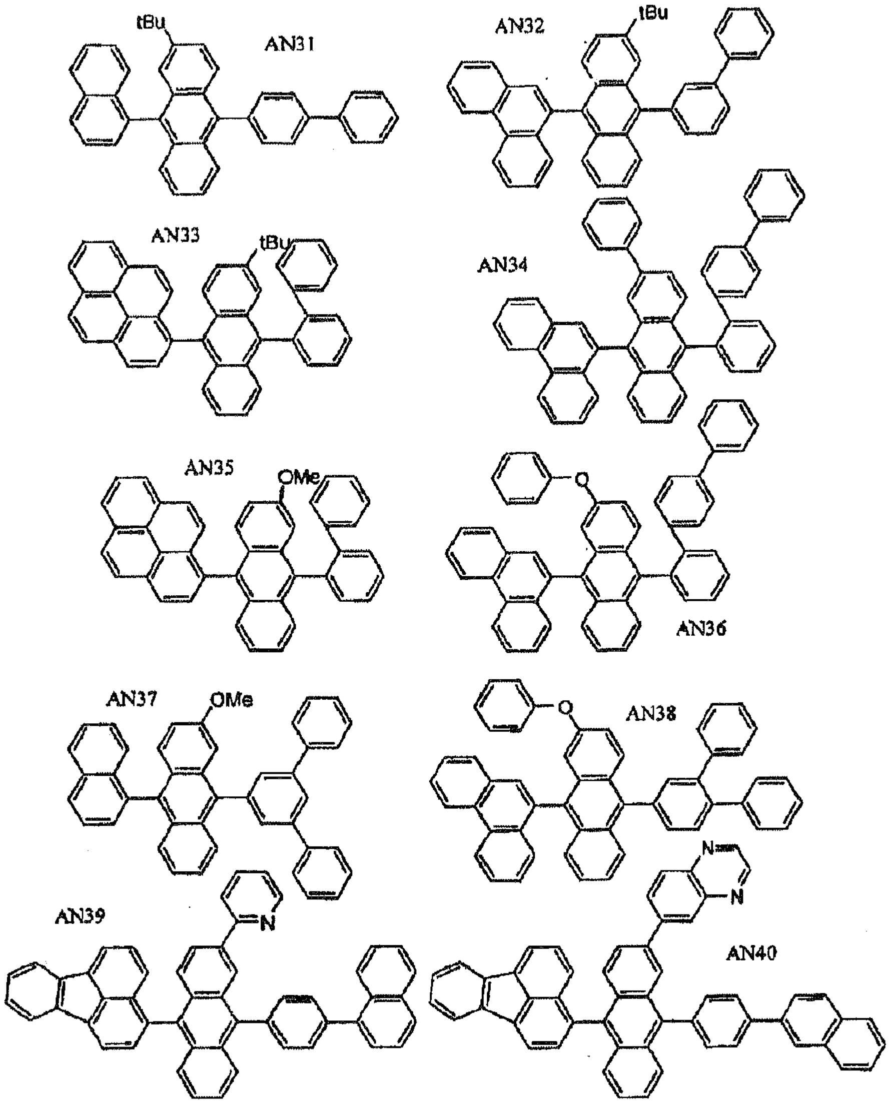

[Formula 11]

AN41

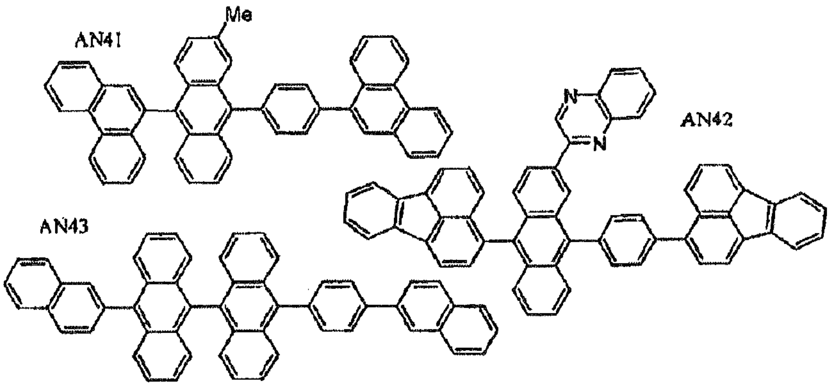

AN42

AN43

AN44

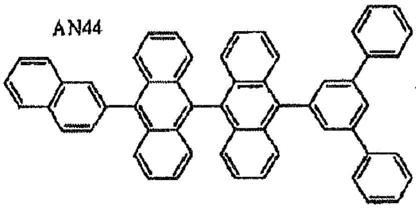

AN45

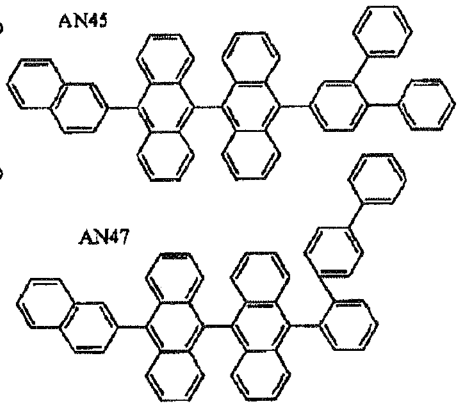

AN46

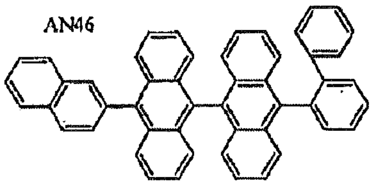

AN47

AN48

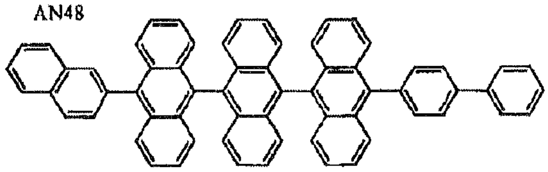

AN49

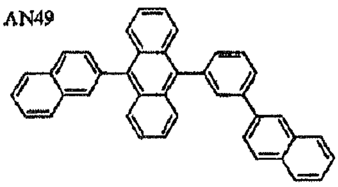

AN50

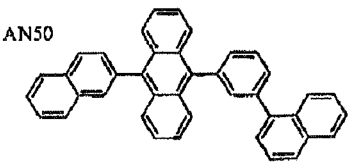

[Formula 12]

AN51

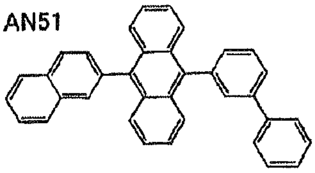

AN52

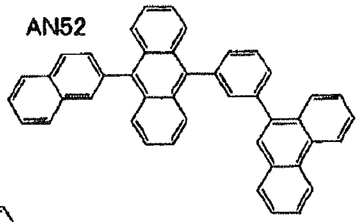

AN53

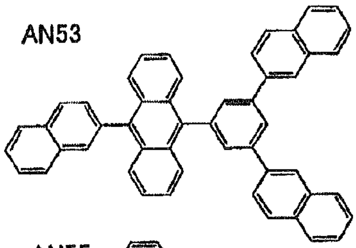

AN54

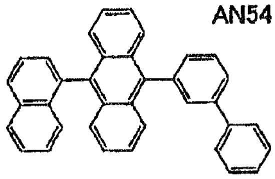

AN55

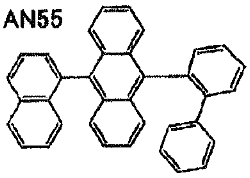

AN56

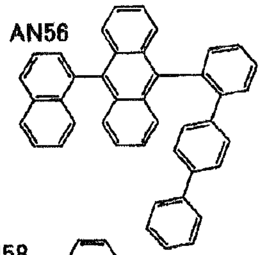

AN57

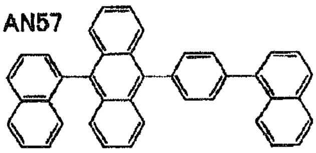

AN58

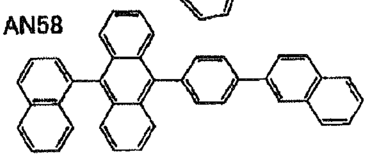

AN59

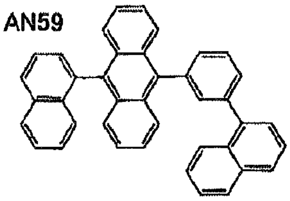

AN60

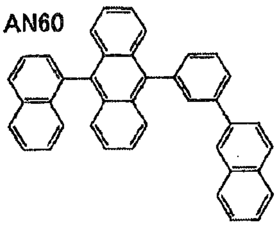

The anthracene derivative may be an asymmetric monoanthracene derivative represented by a formula (3) as follows.

[Formula 13]

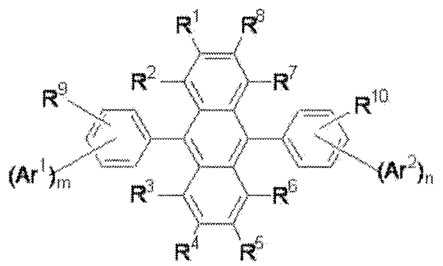

(3)

In the above formula (3); $Ar^1$ and $Ar^2$ are each a substituted or unsubstituted aromatic ring group having 6 to 50 carbon

atoms forming the aromatic ring while m and n are each an integer in a range of 1 to 4, $Ar^1$ and $Ar^2$ being mutually different when: m and n are both equal to 1; and positions at which $Ar^1$ and $Ar^2$ are respectively bonded to benzene rings are symmetric, m and n being mutually different when m or n is an integer in a range of 2 to 4; and

$R^1$ to $R^{10}$ are each a hydrogen atom, a substituted or unsubstituted aromatic ring group having 6 to 50 carbon atoms forming the aromatic ring, a substituted or unsubstituted aromatic heterocycle group having 5 to 50 atoms forming the aromatic ring, a substituted or unsubstituted alkyl group having 1 to 50 carbon atoms, a substituted or unsubstituted cycloalkyl group, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 atoms forming the aromatic ring, a substituted or unsubstituted arylthio group having 5 to 50 atoms forming the aromatic ring, a substituted or unsubstituted alkoxycarbonyl group having 1 to 50 carbon atoms, substituted or unsubstituted silyl group, a carboxyl group, a halogen atom, a cyano group, a nitro group and a hydroxy group.

Examples of such an anthracene derivative are as follows.

[Formula 14]

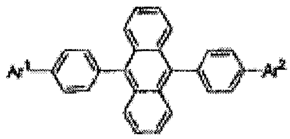

| Compound | $Ar^1$ | $Ar^2$ |
|---|---|---|
| AN-1 | 1-naphthyl | 9-phenanthryl |
| AN-2 | 1-naphthyl | 1-pyrenyl |
| AN-3 | 1-naphthyl | phenyl |
| AN-4 | 1-naphthyl | 2-biphenyl |
| AN-5 | 1-naphthyl | 3-biphenyl |
| AN-6 | 1-naphthyl | 4-biphenyl |
| AN-7 | 1-naphthyl | 2-p-ta-phenyl |
| AN-8 | 2-naphthyl | 1-naphthyl |
| AN-9 | 2-naphthyl | 9-phenanthryl |
| AN-10 | 2-naphthyl | 1-pyrenyl |
| AN-11 | 2-naphthyl | phenyl |
| AN-12 | 2-naphthyl | 2-biphenyl |
| AN-13 | 2-naphthyl | 3-biphenyl |
| AN-14 | 2-naphthyl | 4-biphenyl |
| AN-15 | 2-naphthyl | 2-p-ta-phenyl |
| AN-16 | 9-phenanthryl | 1-pyrenyl |
| AN-17 | 9-phenanthryl | phenyl |
| AN-18 | 9-phenanthryl | 2-biphenyl |
| AN-19 | 9-phenanthryl | 3-biphenyl |
| AN-20 | 9-phenanthryl | 4-biphenyl |

[Formula 15]

| | | |
|---|---|---|
| AN-21 | 9-phenanthryl | 2-p-ta-phenyl |
| AN-22 | 1-biphenyl | phenyl |
| AN-23 | 1-biphenyl | 2-biphenyl |
| AN-24 | 1-biphenyl | 3-biphenyl |
| AN-25 | 1-biphenyl | 4-biphenyl |
| AN-26 | 1-biphenyl | 2-p-ta-phenyl |
| AN-27 | phenyl | 2-biphenyl |
| AN-28 | phenyl | 3-biphenyl |
| AN-29 | phenyl | 4-biphenyl |
| AN-30 | phenyl | 2-p-ta-phenyl |
| AN-31 | 2-biphenyl | 3-biphenyl |
| AN-32 | 2-biphenyl | 4-biphenyl |
| AN-33 | 2-biphenyl | 2-p-ta-phenyl |
| AN-34 | 3-biphenyl | 4-biphenyl |
| AN-35 | 3-biphenyl | 2-p-ta-phenyl |

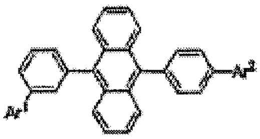

| Compound | $Ar^1$ | $Ar^2$ |
|---|---|---|
| AN-36 | 1-naphthyl | 1-naphthyl |
| AN-37 | 1-naphthyl | 2-naphthyl |
| AN-38 | 1-naphthyl | 9-phenanthryl |
| AN-39 | 1-naphthyl | 1-pyrenyl |

[Formula 16]

| | | |
|---|---|---|
| AN-40 | 1-naphthyl | phenyl |
| AN-41 | 1-naphthyl | 2-biphenyl |
| AN-42 | 1-naphthyl | 3-biphenyl |
| AN-43 | 1-naphthyl | 4-biphenyl |
| AN-44 | 1-naphthyl | 2-p-ta-phenyl |
| AN-45 | 2-naphthyl | 1-naphthyl |
| AN-46 | 2-naphthyl | 2-naphthyl |
| AN-47 | 2-naphthyl | 9-phenanthryl |
| AN-48 | 2-naphthyl | 1-pyrenyl |
| AN-49 | 2-naphthyl | phenyl |

(continued)

| | | |
|---|---|---|
| AN-50 | 2-naphthyl | 2-biphenyl |
| AN-51 | 2-naphthyl | 3-biphenyl |
| AN-52 | 2-naphthyl | 4-biphenyl |
| AN-53 | 2-naphthyl | 2-p-ta-phenyl |
| AN-54 | 9-phenanthryl | 1-naphthyl |
| AN-55 | 9-phenanthryl | 2-naphthyl |
| AN-56 | 9-phenanthryl | 9-phenanthryl |
| AN-57 | 9-phenanthryl | 1-pyrenyl |
| AN-58 | 9-phenanthryl | phenyl |
| AN-59 | 9-phenanthryl | 2-biphenyl |
| AN-60 | 9-phenanthryl | 3-biphenyl |
| AN-61 | 9-phenanthryl | 4-biphenyl |
| AN-62 | 9-phenanthryl | 2-p-ta-phenyl |
| AN-63 | 1-pyrenyl | 1-naphthyl |
| AN-64 | 1-pyrenyl | 2-naphthyl |

[Formula 17]

| | | |
|---|---|---|
| AN-65 | 1-pyrenyl | 9-phenanthryl |
| AN-66 | 1-pyrenyl | 1-pyrenyl |
| AN-67 | 1-pyrenyl | phenyl |
| AN-68 | 1-pyrenyl | 2-biphenyl |
| AN-69 | 1-pyrenyl | 3-biphenyl |
| AN-70 | 1-pyrenyl | 4-biphenyl |
| AN-71 | 1-pyrenyl | 2-p-ta-phenyl |
| AN-72 | phenyl | 1-naphthyl |
| AN-73 | phenyl | 2-naphthyl |
| AN-74 | phenyl | 9-phenanthryl |
| AN-75 | phenyl | 1-pyrenyl |
| AN-76 | phenyl | phenyl |
| AN-77 | phenyl | 2-biphenyl |
| AN-78 | phenyl | 3-biphenyl |
| AN-79 | phenyl | 4-biphenyl |
| AN-80 | phenyl | 2-p-ta-phenyl |
| AN-81 | 2-biphenyl | 1-naphthyl |
| AN-82 | 2-biphenyl | 2-naphthyl |
| AN-83 | 2-biphenyl | 9-phenanthryl |
| AN-84 | 2-biphenyl | 1-pyrenyl |
| AN-85 | 2-biphenyl | phenyl |

(continued)

| | | |
|---|---|---|
| AN-86 | 2-biphenyl | 2-biphenyl |
| AN-87 | 2-biphenyl | 3-biphenyl |
| AN-88 | 2-biphenyl | 4-biphenyl |

[Formula 18]

| | | |
|---|---|---|
| AN-89 | 2-biphenyl | 2-p-ta-phenyl |
| AN-90 | 3-biphenyl | 1-naphthyl |
| AN-91 | 3-biphenyl | 2-naphthyl |
| AN-92 | 3-biphenyl | 9-phenanthryl |
| AN-93 | 3-biphenyl | 1-pyrenyl |
| AN-94 | 3-biphenyl | phenyl |
| AN-95 | 3-biphenyl | 2-biphenyl |
| AN-96 | 3-biphenyl | 3-biphenyl |
| AN-97 | 3-biphenyl | 4-biphenyl |
| AN-98 | 3-biphenyl | 2-p-ta-phenyl |
| AN-99 | 4-biphenyl | 1-naphthyl |
| AN-100 | 4-biphenyl | 2-naphthyl |
| AN-101 | 4-biphenyl | 9-phenanthryl |
| AN-102 | 4-biphenyl | 1-pyrenyl |
| AN-103 | 4-biphenyl | phenyl |
| AN-104 | 4-biphenyl | 2-biphenyl |
| AN-105 | 4-biphenyl | 3-biphenyl |
| AN-106 | 4-biphenyl | 4-biphenyl |
| AN-107 | 4-biphenyl | 2-p-ta-phenyl |

[Formula 19]

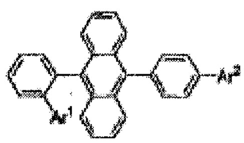

| Compound | $Ar^1$ | $Ar^2$ |
|---|---|---|
| AN-108 | 1-naphthyl | 1-naphthyl |
| AN-109 | 1-naphthyl | 2-naphthyl |
| AN-110 | 1-naphthyl | 9-phenanthryl |
| AN-111 | 1-naphthyl | 1-pyrenyl |

(continued)

| Compound | $Ar^1$ | $Ar^2$ |
|---|---|---|
| AN-112 | 1-naphthyl | phenyl |
| AN-113 | 1-naphthyl | 2-biphenyl |
| AN-114 | 1-naphthyl | 3-biphenyl |
| AN-115 | 1-naphthyl | 4-biphenyl |
| AN-116 | 1-naphthyl | 2-p-ta-phenyl |
| AN-117 | 2-naphthyl | 1-naphthyl |
| AN-118 | 2-naphthyl | 2-naphthyl |
| AN-119 | 2-naphthyl | 9-phenanthryl |
| AN-120 | 2-naphthyl | 1-pyrenyl |
| AN-121 | 2-naphthyl | phenyl |
| AN-122 | 2-naphthyl | 2-biphenyl |
| AN-123 | 2-naphthyl | 3-biphenyl |
| AN-124 | 2-naphthyl | 4-biphenyl |
| AN-125 | 2-naphthyl | 2-p-ta-phenyl |
| AN-126 | 9-phenanthryl | 1-naphthyl |
| AN-127 | 9-phenanthryl | 2-naphthyl |

[Formula 20]

| | | |
|---|---|---|
| AN-128 | 9-phenanthryl | 9-phenanthryl |
| AN-129 | 9-phenanthryl | 1-pyrenyl |
| AN-130 | 9-phenanthryl | phenyl |
| AN-131 | 9-phenanthryl | 2-biphenyl |
| AN-132 | 9-phenanthryl | 3-biphenyl |
| AN-133 | 9-phenanthryl | 4-biphenyl |
| AN-134 | 9-phenanthryl | 2-p-ta-phenyl |
| AN-13 5 | 1-pyrenyl | 1-naphthyl |
| AN-136 | 1-pyrenyl | 2-naphthyl |
| AN-13 7 | 1-pyrenyl | 9-phenanthryl |
| AN-138 | 1-pyrenyl | 1-pyrenyl |
| AN-139 | 1-pyrenyl | phenyl |
| AN-140 | 1-pyrenyl | 2-biphenyl |
| AN-141 | 1-pyrenyl | 3-biphenyl |
| AN-142 | 1-pyrenyl | 4-biphenyl |
| AN-143 | 1-pyrenyl | 2-p-ta-phenyl |
| AN-144 | phenyl | 1-naphthyl |
| AN-145 | phenyl | 2-naphthyl |
| AN-146 | phenyl | 9-phenanthryl |

(continued)

| | | |
|---|---|---|
| AN-147 | phenyl | 1-pyrenyl |
| AN-148 | phenyl | phenyl |
| AN-149 | phenyl | 2-biphenyl |
| AN-150 | phenyl | 3-biphenyl |
| AN-151 | phenyl | 4-biphenyl |
| AN-152 | phenyl | 2-p-ta-phenyl |

[Formula 21]

| | | |
|---|---|---|
| AN-153 | 2-biphenyl | 1-naphthyl |
| AN-154 | 2-biphenyl | 2-naphthyl |
| AN-155 | 2-biphenyl | 9-phenanthryl |
| AN-156 | 2-biphenyl | 1-pyrenyl |
| AN-157 | 2-biphenyl | phenyl |
| AN-158 | 2-biphenyl | 2-biphenyl |
| AN-159 | 2-biphenyl | 3-biphenyl |
| AN-160 | 2-biphenyl | 4-biphenyl |
| AN-161 | 2-biphenyl | 2-p-ta-phenyl |
| AN-162 | 3-biphenyl | 1-naphthyl |
| AN-163 | 3-biphenyl | 2-naphthyl |
| AN-164 | 3-biphenyl | 9-phenanthryl |
| AN-165 | 3-biphenyl | 1-pyrenyl |
| AN-166 | 3-biphenyl | phenyl |
| AN-167 | 3-biphenyl | 2-biphenyl |
| AN-168 | 3-biphenyl | 3-biphenyl |
| AN-169 | 3-biphenyl | 4-biphenyl |
| AN-170 | 3-biphenyl | 2-p-ta-phenyl |
| AN-171 | 4-biphenyl | 1-naphthyl |
| AN-172 | 4-biphenyl | 2-naphthyl |
| AN-173 | 4-biphenyl | 9-phenanthryl |
| AN-174 | 4-biphenyl | 1-pyrenyl |
| AN-175 | 4-biphenyl | phenyl |
| AN-176 | 4-biphenyl | 2-biphenyl |

[Formula 22]

| | | |
|---|---|---|
| AN-177 | 4-biphenyl | 3-biphenyl |
| AN-178 | 4-biphenyl | 4-biphenyl |
| AN-179 | 4-biphenyl | 2-p-ta-phenyl |

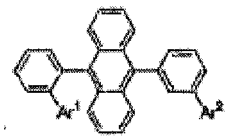

| Compound | $Ar^1$ | $Ar^2$ |
|---|---|---|
| AN-180 | 1-naphthyl | 1-naphthyl |
| AN-181 | 1-naphthyl | 2-naphthyl |
| AN-182 | 1-naphthyl | 9-phenanthryl |
| AN-183 | 1-naphthyl | 1-pyrenyl |
| AN-184 | 1-naphthyl | phenyl |
| AN-185 | 1-naphthyl | 2-biphenyl |
| AN-186 | 1-naphthyl | 3-biphenyl |
| AN-187 | 1-naphthyl | 4-biphenyl |
| AN-188 | 2-naphthyl | 1-naphthyl |
| AN-189 | 2-naphthyl | 2-naphthyl |
| AN-190 | 2-naphthyl | 9-phenanthryl |
| AN-191 | 2-naphthyl | 1-pyrenyl |
| AN-192 | 2-naphthyl | phenyl |
| AN-193 | 2-naphthyl | 2-biphenyl |
| AN-194 | 2-naphthyl | 3-biphenyl |
| AN-195 | 2-naphthyl | 4-biphenyl |

[Formula 23]

| | | |
|---|---|---|
| AN-196 | 9-phenanthryl | 1-naphthyl |
| AN-197 | 9-phenanthryl | 2-naphthyl |
| AN-198 | 9-phenanthryl | 9-phenanthryl |
| AN-199 | 9-phenanthryl | 1-pyrenyl |
| AN-200 | 9-phenanthryl | phenyl |
| AN-201 | 9-phenanthryl | 2-biphenyl |
| AN-202 | 9-phenanthryl | 3-biphenyl |
| AN-203 | 9-phenanthryl | 4-biphenyl |
| AN-204 | 1-pyrenyl | 1-naphthyl |
| AN-205 | 1-pyrenyl | 2-naphthyl |
| AN-206 | 1-pyrenyl | 9-phenanthryl |
| AN-207 | 1-pyrenyl | 1-pyrenyl |
| AN-208 | 1-pyrenyl | phenyl |
| AN-209 | 1-pyrenyl | 2-biphenyl |
| AN-210 | 1-pyrenyl | 3-biphenyl |

(continued)

| | | |
|---|---|---|
| AN-211 | 1-pyrenyl | 4-biphenyl |
| AN-212 | phenyl | 1-naphthyl |
| AN-213 | phenyl | 2-naphthyl |
| AN-214 | phenyl | 9-phenanthryl |
| AN-215 | phenyl | 1-pyrenyl |
| AN-216 | phenyl | phenyl |
| AN-217 | phenyl | 2-biphenyl |
| AN-218 | phenyl | 3-biphenyl |
| AN-219 | phenyl | 4-biphenyl |
| AN-220 | 2-biphenyl | 1-naphthyl |

[Formula 24]

| | | |
|---|---|---|
| AN-221 | 2-biphenyl | 2-naphthyl |
| AN-222 | 2-biphenyl | 9-phenanthryl |
| AN-223 | 2-biphenyl | 1-pyrenyl |
| AN-224 | 2-biphenyl | phenyl |
| AN-225 | 2-biphenyl | 2-biphenyl |
| AN-226 | 2-biphenyl | 3-biphenyl |
| AN-227 | 2-biphenyl | 4-biphenyl |
| AN-228 | 3-biphenyl | 1-naphthyl |
| AN-229 | 3-biphenyl | 2-naphthyl |
| AN-230 | 3-biphenyl | 9-phenanthryl |
| AN-231 | 3-biphenyl | 1-pyrenyl |
| AN-232 | 3-biphenyl | phenyl |
| AN-233 | 3-biphenyl | 2-biphenyl |
| AN-234 | 3-biphenyl | 3-biphenyl |
| AN-235 | 3-biphenyl | 4-biphenyl |
| AN-236 | 4-biphenyl | 1-naphthyl |
| AN-237 | 4-biphenyl | 2-naphthyl |
| AN-238 | 4-biphenyl | 9-phenanthryl |
| AN-239 | 4-biphenyl | 1-pyrenyl |
| AN-240 | 4-biphenyl | phenyl |
| AN-241 | 4-biphenyl | 2-biphenyl |
| AN-242 | 4-biphenyl | 3-biphenyl |
| AN-243 | 4-biphenyl | 4-biphenyl |

[Formula 25]

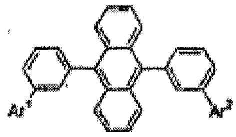

| Compound | $Ar^1$ | $Ar^2$ |
|---|---|---|
| AN-244 | 1-naphthyl | 2-naphthyl |
| AN-245 | 1-naphthyl | 9-phenanthryl |
| AN-246 | 1-naphthyl | 1-pyrenyl |
| AN-247 | 1-naphthyl | phenyl |
| AN-248 | 1-naphthyl | 2-biphenyl |
| AN-249 | 1-naphthyl | 3-biphenyl |
| AN-250 | 1-naphthyl | 4-biphenyl |
| AN-251 | 2-naphthyl | 9-phenanthryl |
| AN-252 | 2-naphthyl | 1-pyrenyl |
| AN-253 | 2-naphthyl | phenyl |
| AN-254 | 2-naphthyl | 2-biphenyl |
| AN-255 | 2-naphthyl | 3-biphenyl |
| AN-256 | 2-naphthyl | 4-biphenyl |
| AN-257 | 9-phenanthryl | 1-pyrenyl |
| AN-258 | 9-phenanthryl | phenyl |
| AN-259 | 9-phenanthryl | 2-biphenyl |
| AN-260 | 9-phenanthryl | 3-biphenyl |
| AN-261 | 9-phenanthryl | 4-biphenyl |
| AN-262 | 1-pyrenyl | phenyl |
| AN-263 | 1-pyrenyl | 2-biphenyl |

[Formula 26]

| | | |
|---|---|---|
| AN-264 | 1-pyrenyl | 3-biphenyl |
| AN-265 | 1-pyrenyl | 4-biphenyl |
| AN-266 | phenyl | 2-biphenyl |
| AN-267 | phenyl | 3-biphenyl |
| AN-268 | phenyl | 4-biphenyl |
| AN-269 | 2-biphenyl | 3-biphenyl |
| AN-270 | 2-biphenyl | 4-biphenyl |
| AN-271 | 3-biphenyl | 4-biphenyl |

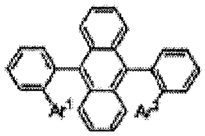

| Compound | $Ar^1$ | $Ar^2$ |
|---|---|---|
| AN-272 | 1-naphthyl | 2-naphthyl |
| AN-273 | 1-naphthyl | 9-phenanthryl |
| AN-274 | 1-naphthyl | 1-pyrenyl |
| AN-275 | 1-naphthyl | phenyl |
| AN-276 | 1-naphthyl | 2-biphenyl |
| AN-277 | 1-naphthyl | 3-biphenyl |
| AN-278 | 1-naphthyl | 4-biphenyl |
| AN-279 | 2-naphthyl | 9-phenanthryl |
| AN-280 | 2-naphthyl | 1-pyrenyl |
| AN-281 | 2-naphthyl | phenyl |
| AN-282 | 2-naphthyl | 2-biphenyl |

[Formula 27]

| | | |
|---|---|---|
| AN-283 | 2-naphthyl | 3-biphenyl |
| AN-284 | 2-naphthyl | 4-biphenyl |
| AN-285 | 9-phenanthryl | 1-pyrenyl |
| AN-286 | 9-phenanthryl | phenyl |
| AN-287 | 9-phenanthryl | 2-biphenyl |
| AN-288 | 9-phenanthryl | 3-biphenyl |
| AN-289 | 9-phenanthryl | 4-biphenyl |
| AN-290 | 1-pyrenyl | phenyl |
| AN-291 | 1-pyrenyl | 2-biphenyl |
| AN-292 | 1-pyrenyl | 3-biphenyl |
| AN-293 | 1-pyrenyl | 4-biphenyl |
| AN-294 | phenyl | 2-biphenyl |
| AN-295 | phenyl | 3-biphenyl |
| AN-296 | phenyl | 4-biphenyl |
| AN-297 | 2-biphenyl | 3-biphenyl |
| AN-298 | 2-biphenyl | 4-biphenyl |
| AN-299 | 3-biphenyl | 4-biphenyl |

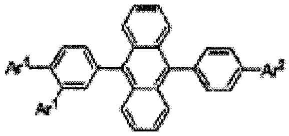

| Compound | Ar1 | Ar2 |
|---|---|---|
| AN-300 | 1-naphthyl | 1-naphthyl |
| AN-301 | 1-naphthyl | 2-naphthyl |

[Formula 28]

| | | |
|---|---|---|
| AN-302 | 1-naphthyl | 9-phenanthryl |
| AN-303 | 1-naphthyl | 1-pyrenyl |
| AN-304 | 1-naphthyl | phenyl |
| AN-305 | 1-naphthyl | 2-biphenyl |
| AN-306 | 1-naphthyl | 3-biphenyl |
| AN-307 | 1-naphthyl | 4-biphenyl |
| AN-308 | 1-naphthyl | 2-p-ta-phenyl |
| AN-309 | 2-naphthyl | 1-naphthyl |
| AN-310 | 2-naphthyl | 2-naphthyl |
| AN-311 | 2-naphthyl | 9-phenanthryl |
| AN-312 | 2-naphthyl | 1-pyrenyl |
| AN-313 | 2-naphthyl | phenyl |
| AN-314 | 2-naphthyl | 2-biphenyl |
| AN-315 | 2-naphthyl | 3-biphenyl |
| AN-316 | 2-naphthyl | 4-biphenyl |
| AN-317 | 2-naphthyl | 2-p-ta-phenyl |

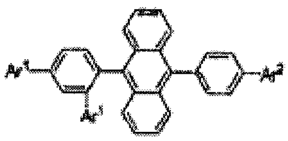

| Compound | Ar1 | Ar2 |
|---|---|---|
| AN-318 | 1 -naphthyl | 1-naphthyl |
| AN-319 | 1-naphthyl | 2-naphthyl |
| AN-320 | 1-naphthyl | 9-phenanthryl |

[Formula 29]

| | | |
|---|---|---|
| AN-321 | 1-naphthyl | 1-pyrenyl |
| AN-322 | 1-naphthyl | phenyl |
| AN-323 | 1-naphthyl | 2-biphenyl |
| AN-324 | 1-naphthyl | 3-biphenyl |
| AN-325 | 1-naphthyl | 4-biphenyl |
| AN-326 | 1-naphthyl | 2-p-ta-phenyl |
| AN-327 | 2-naphthyl | 1-naphthyl |
| AN-328 | 2-naphthyl | 2-naphthyl |
| AN-329 | 2-naphthyl | 9-phenanthryl |
| AN-330 | 2-naphthyl | 1-pyrenyl |
| AN-331 | 2-naphthyl | phenyl |
| AN-332 | 2-naphthyl | 2-biphenyl |
| AN-333 | 2-naphthyl | 3-biphenyl |
| AN-334 | 2-naphthyl | 4-biphenyl |
| AN-335 | 2-naphthyl | 2-p-ta-phenyl |

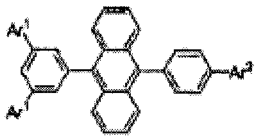

| Compound | $Ar^1$ | $Ar^2$ |
|---|---|---|
| AN-336 | 1-naphthyl | 1-naphthyl |
| AN-337 | 1-naphthyl | 2-naphthyl |
| AN-338 | 1-naphthyl | 9-phenanthryl |
| AN-339 | 1-naphthyl | 1-pyrenyl |

[Formula 30]

| | | |
|---|---|---|
| AN-340 | 1-naphthyl | phenyl |
| AN-341 | 1-naphthyl | 2-biphenyl |
| AN-342 | 1-naphthyl | 3-biphenyl |
| AN-343 | 1-naphthyl | 4-biphenyl |
| AN-344 | 1-naphthyl | 2-p-ta-phenyl |
| AN-345 | 2-naphthyl | 1-naphthyl |
| AN-346 | 2-naphthyl | 2-naphthyl |
| AN-347 | 2-naphthyl | 9-phenanthryl |
| AN-348 | 2-naphthyl | 1-pyrenyl |
| AN-349 | 2-naphthyl | phenyl |

(continued)

| | | |
|---|---|---|
| AN-350 | 2-naphthyl | 2-biphenyl |
| AN-351 | 2-naphthyl | 3-biphenyl |
| AN-352 | 2-naphthyl | 4-biphenyl |
| AN-353 | 2-naphthyl | 2-p-ta-phenyl |

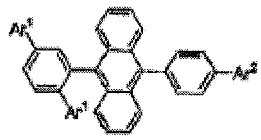

| Compound | $Ar^1$ | $Ar^2$ |
|---|---|---|
| AN-354 | 1-naphthyl | 1-naphthyl |
| AN-355 | 1-naphthyl | 2-naphthyl |
| AN-356 | 1-naphthyl | 9-phenanthryl |
| AN-357 | 1-naphthyl | 1-pyrenyl |
| AN-358 | 1-naphthyl | phenyl |

[Formula 31]

| | | |
|---|---|---|
| AN-359 | 1-naphthyl | 2-biphenyl |
| AN-360 | 1-naphthyl | 3-biphenyl |
| AN-361 | 1-naphthyl | 4-biphenyl |
| AN-362 | 1-naphthyl | 2-p-ta-phenyl |
| AN-363 | 2-naphthyl | 1-naphthyl |
| AN-364 | 2-naphthyl | 2-naphthyl |
| AN-365 | 2-naphthyl | 9-phenanthryl |
| AN-366 | 2-naphthyl | 1-pyrenyl |
| AN-367 | 2-naphthyl | phenyl |
| AN-368 | 2-naphthyl | 2-biphenyl |
| AN-369 | 2-naphthyl | 3-biphenyl |
| AN-370 | 2-naphthyl | 4-biphenyl |
| AN-371 | 2-naphthyl | 2-p-ta-phenyl |

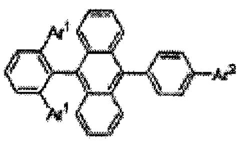

| Compound | $Ar^1$ | $Ar^2$ |
|---|---|---|
| AN-372 | 1-naphthyl | 1-naphthyl |
| AN-373 | 1-naphthyl | 2-naphthyl |
| AN-374 | 1-naphthyl | 9-phenanthryl |
| AN-375 | 1-naphthyl | 1-pyrenyl |
| AN-376 | 1-naphthyl | phenyl |
| AN-377 | 1-naphthyl | 2-biphenyl |

[Formula 32]

| | | |
|---|---|---|
| AN-378 | 1-naphthyl | 3-biphenyl |
| AN-379 | 1-naphthyl | 4-biphenyl |
| AN-380 | 1-naphthyl | 2-p-ta-phenyl |
| AN-3 81 | 2-naphthyl | 1-naphthyl |
| AN-382 | 2-naphthyl | 2-naphthyl |
| AN-383 | 2-naphthyl | 9-phenanthryl |
| AN-384 | 2-naphthyl | 1-pyrenyl |
| AN-385 | 2-naphthyl | phenyl |
| AN-386 | 2-naphthyl | 2-biphenyl |
| AN-387 | 2-naphthyl | 3-biphenyl |
| AN-388 | 2-naphthyl | 4-biphenyl |
| AN-389 | 2-naphthyl | 2-p-ta-phenyl |

[Formula 33]

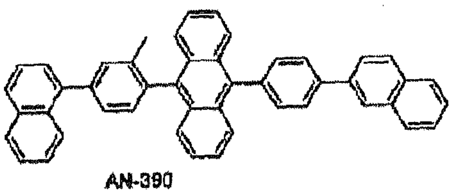

AN-390

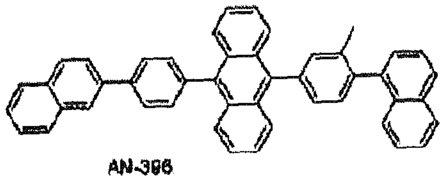

AN-396

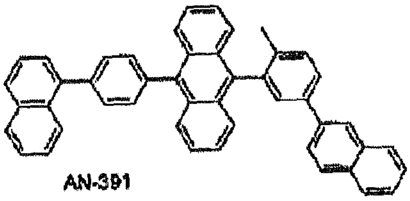

AN-391

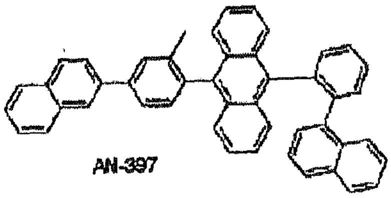

AN-397

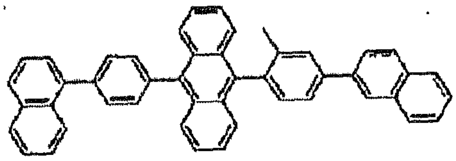

AN-392

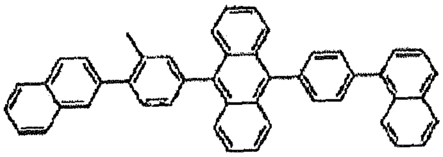

AN-398

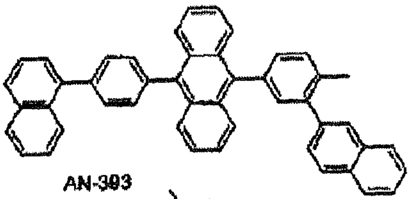

AN-393

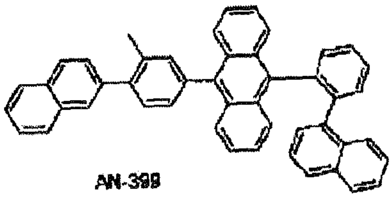

AN-399

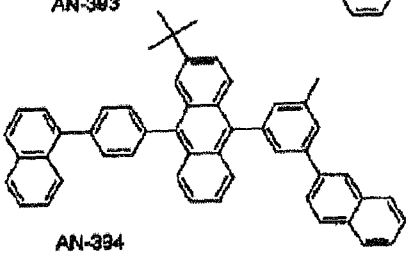

AN-394

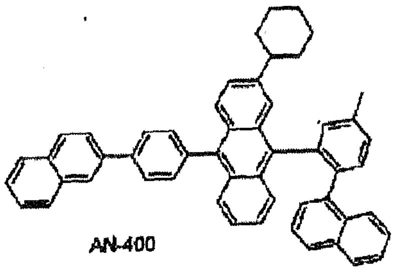

AN-400

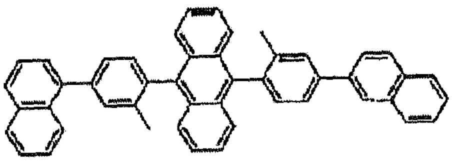

AN-395

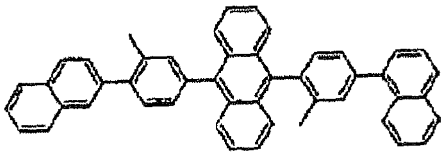

AN-401

[Formula 34]

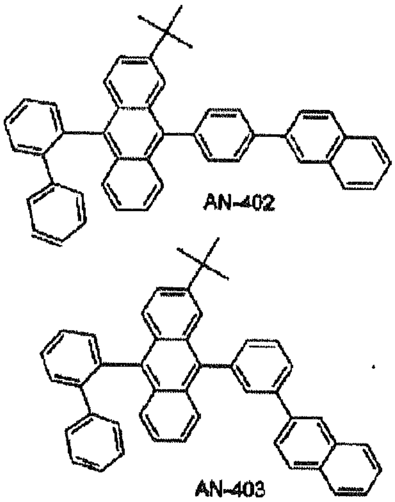

AN-402

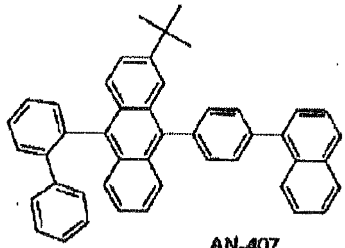

AN-407

AN-403

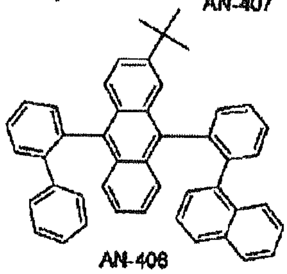

AN-408

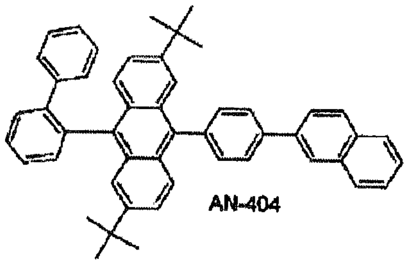

AN-404

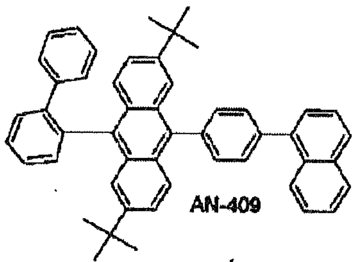

AN-409

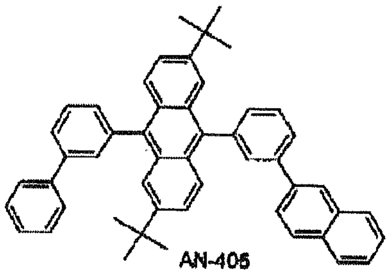

AN-405

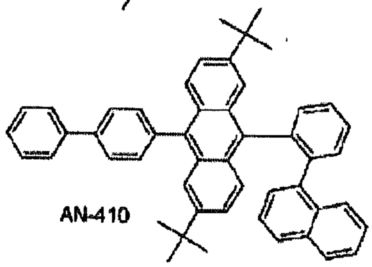

AN-410

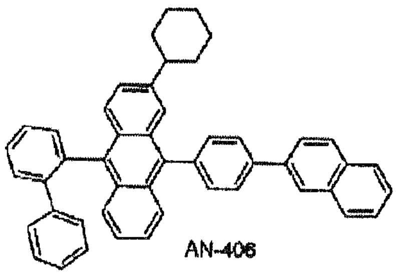

AN-406

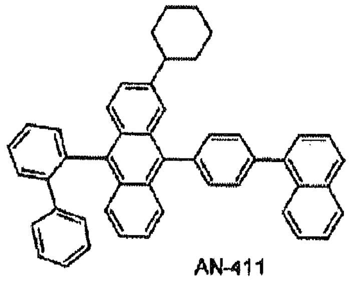

AN-411

[Formula 35]

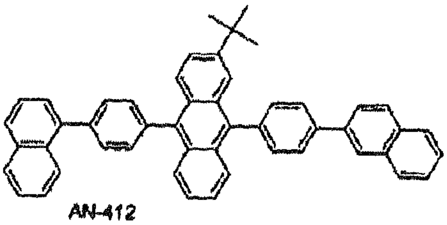
AN-412

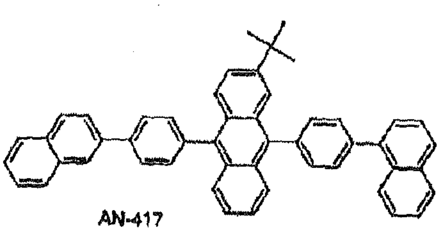
AN-417

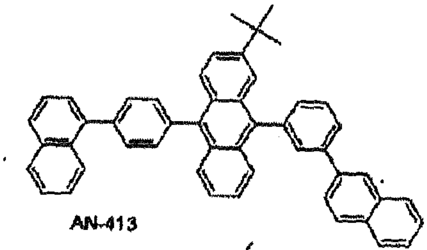
AN-413

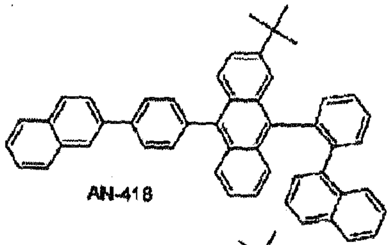
AN-418

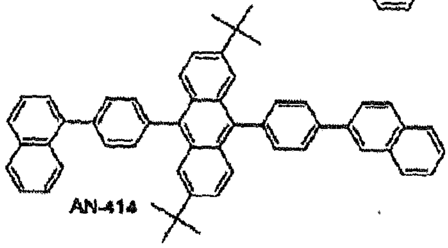
AN-414

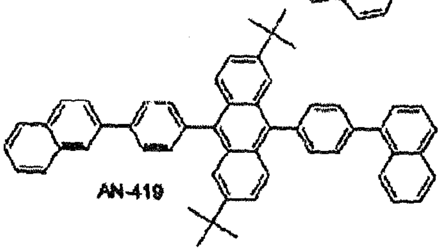
AN-419

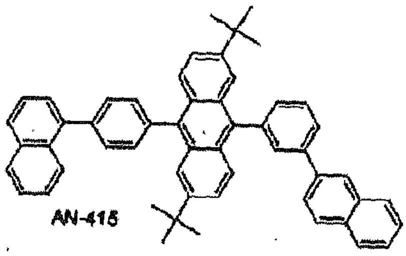
AN-415

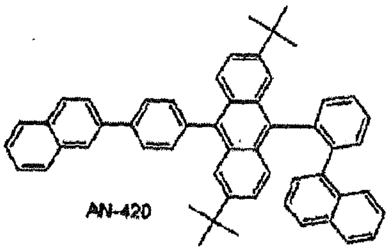
AN-420

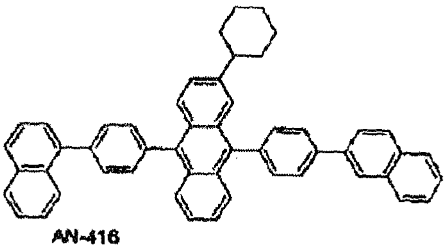
AN-416

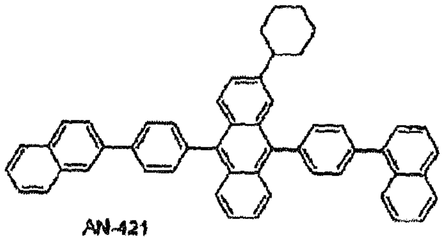
AN-421

The anthracene derivative may be a compound represented by a formula (4) as follows.

[Formula 36]

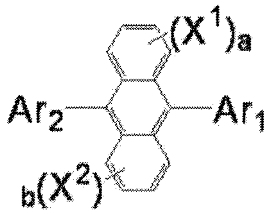

(4)

In the above formula (4); at least either one of $Ar^1$ and $Ar^2$ is a substituent having a substituted or unsubstituted fused ring group with 10 to 30 carbon atoms forming the aromatic ring;

$X^1$ and $X^2$ are each a substituted or unsubstituted aromatic group having 6 to 50 carbon atoms forming the aromatic ring, a substituted or unsubstituted aromatic heterocycle group having 5 to 50 carbon atoms forming the aromatic ring, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 carbon atoms, a substituted or unsubstituted arylthio group having 5 to 50 carbon atoms, a substituted or unsubstituted alkoxycarbonyl group having 1 to 50 carbon atoms, a carboxyl group, a halogen group, a cyano group, a nitro group and hydroxyl group; and

a and b are each an integer in a range of 0 to 4, a plurality of $X^1$ being mutually the same or different when a is 2 or more, a plurality of $X^2$ being mutually the same or different when b is 2 or more.

Examples of a substituent group of $Ar^1$ and $Ar^2$ in the formula (4), the substituent group including a fused ring group with 10 to 30 carbon atoms forming the aromatic ring, are a substituted or unsubstituted α-naphthyl group, a substituted or unsubstituted β-naphthyl group, a substituted or unsubstituted phenanthryl group, a substituted or unsubstituted crycenyl group, a substituted or unsubstituted tetracenyl group, a substituted or unsubstited pyrenyl group, a substituted or unsubstituted phenylnaphthyl group, a substituted or unsubstituted naphthylnaphthyl group, a substituted or unsubstituted naphthylphenyl group, a substituted or unsubstituted phenylpyrenyl group, a substituted or unsubstituted pyrenylphenyl group, a substituted or unsubstituted naphthylnaphthylnaphthyl group, a substituted or unsubstituted naphthylnaphthylphenyl group, a substituted or unsubstituted naphthylphenylnaphthyl group, a substituted or unsubstituted phenylnaphthylnaphthyl group, a substituted or unsubstituted phenylnaphthylphenyl group, a substituted or unsubstituted phenylphenylnaphthyl group.

A preferable group among the above is a substituted or unsubstituted α-naphthyl group, a substituted or unsubstituted β-naphthyl group, a substituted or unsubstituted phenylnaphthyl group, a substituted or unsubstituted naphthylnaphthyl group or a substituted or unsubstituted naphthylphenyl group.

Examples of such an anthracene derivative are as follows.

[Formula 37]

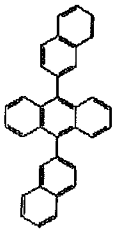
2a-1

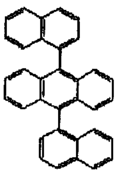
2a-2

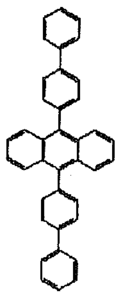
2a-3

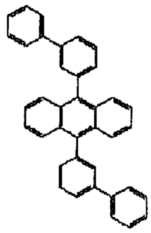
2a-4

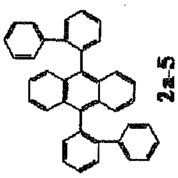
2a-5

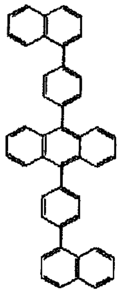
2a-6

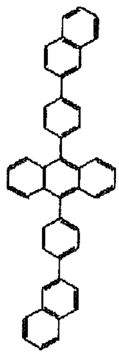
2a-7

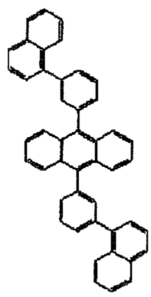
2a-8

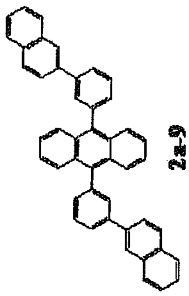
2a-9

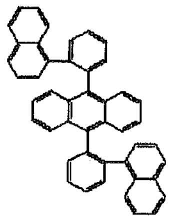
2a-10

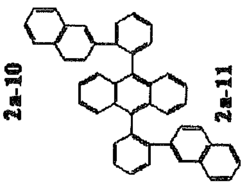
2a-11

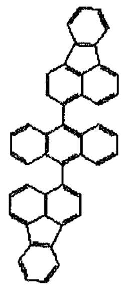
2a-12

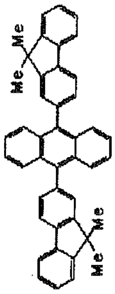
2a-13

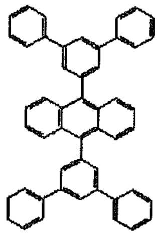
2a-14

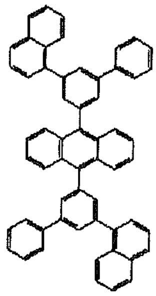
2a-15

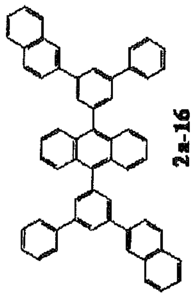
2a-16

[Formula 38]

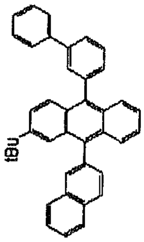
2a'-64

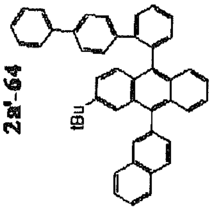
2a'-65

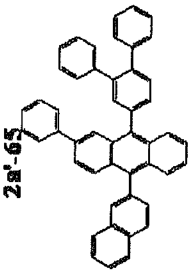
2a'-66

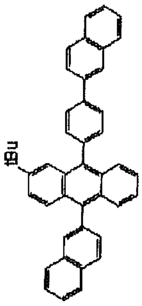
2a'-67

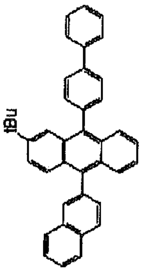
2a'-60

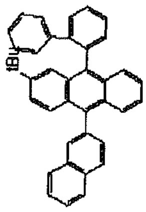
2a'-61

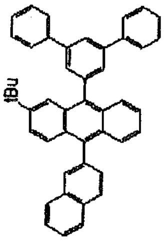
2a'-62

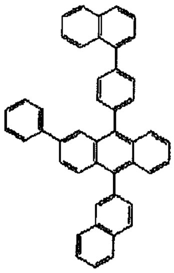
2a'-63

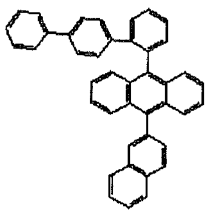
2a'-57

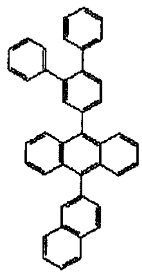
2a'-58

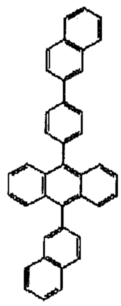
2a'-59

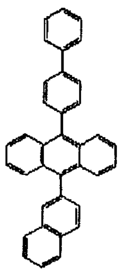
2a'-52

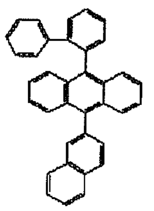
2a'-53

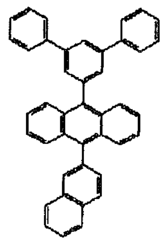
2a'-54

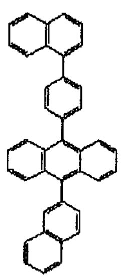
2a'-55

[Formula 39]

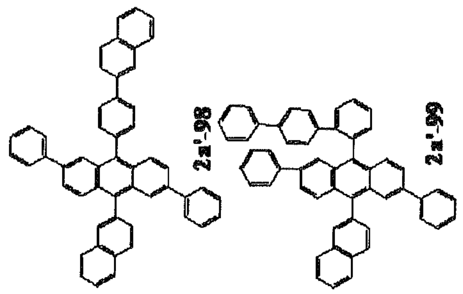
2a'-98
2a'-99

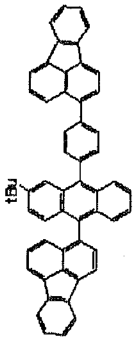
2a'-127

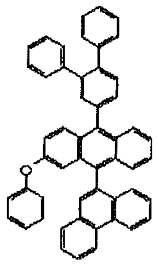
2a'-83

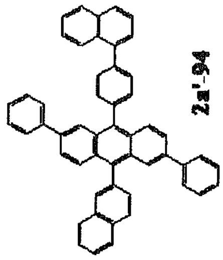
2a'-94

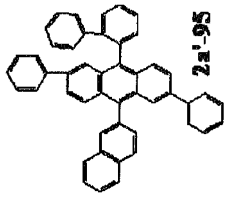
2a'-95

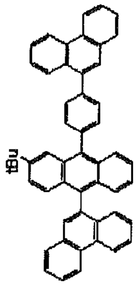
2a'-123

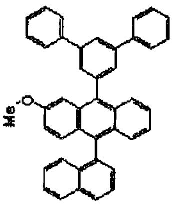
2a'-79

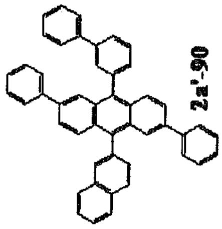
2a'-90

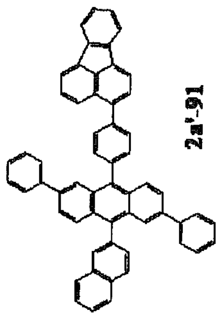
2a'-91

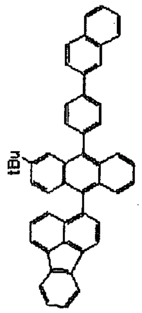
2a'-126

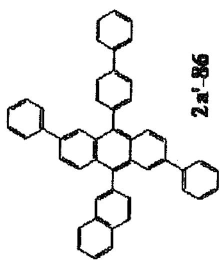
2a'-86

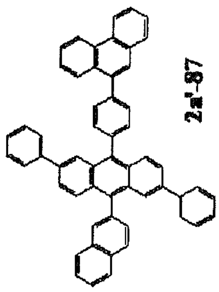
2a'-87

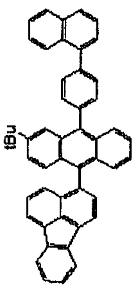
2a'-122

Examples of a dopant used together with the host containing the above anthracene derivative are a styrylamine derivative represented by a formula (5) as follows and a substituted derivative of arylamine represented by a formula (6) as follows.

[Formula 40]

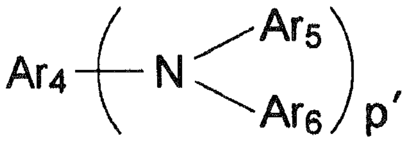

(5)

In the formula (5), at least one of $Ar_4$ to $Ar_6$ includes a styryl group. Preferably, $Ar_4$ is selected from a group consisting of a phenyl group, a biphenyl group, a terphenyl group, a stilbene group and a distyryl-aryl group while $Ar_5$ and $Ar_6$ are either one of a hydrogen atom and an aromatic group having 6 to 20 carbon atoms. P' represents an integer in a range of 1 to 4.

The aromatic group having 6 to 20 carbon atoms is preferably a phenyl group, a naphthyl group, an anthracenyl group, a phenanthryl group, a terphenyl group or the like.

[Formula 41]

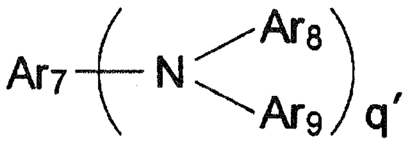

(6)

In the formula (6) above, $Ar_7$ to $Ar_9$ each represent a substituted or unsubstituted aryl group with 5 to 40 carbon atoms forming the aromatic ring. q' is an integer in a range of 1 to 4.

In the formula above, the aryl group having 5 to 40 ring atoms is preferably phenyl, naphthyl, anthracenyl, phenanthryl, pyrenyl, chrysenyl, coronyl, biphenyl, terphenyl, pyrrolyl, furanyl, thiophenyl, benzothiophenyl, oxadiazolyl, diphenyl anthracenyl, indolyl, carbazolyl, pyridyl, benzoquinolyl, fluorenyl, fluoranthenyl, acenaphthofluoranthenyl, stilbene, a group represented by a general formula (A) or (B) below or the like.

In the general formula (A), r is an integer in a range of 1 to 3.

[Formula 42]

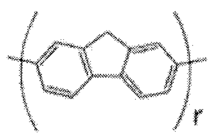

(A)

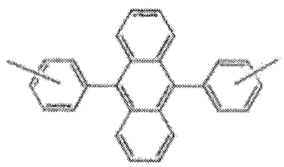

(B)

The aryl group having 5 to 40 ring atoms may be substituted by a substituent group, in which the substituent group is preferably an alkyl group having 2 to 6 carbon atoms (e.g., an ethyl group, a methyl group, an isopropyl group, an n-propyl group, an s-butyl group, a t-butyl group, a pentyl group, a hexyl group, a cyclopentyl group and a cyclohexyl group).

Examples of the dopant are compounds shown below.

[Formula 43]

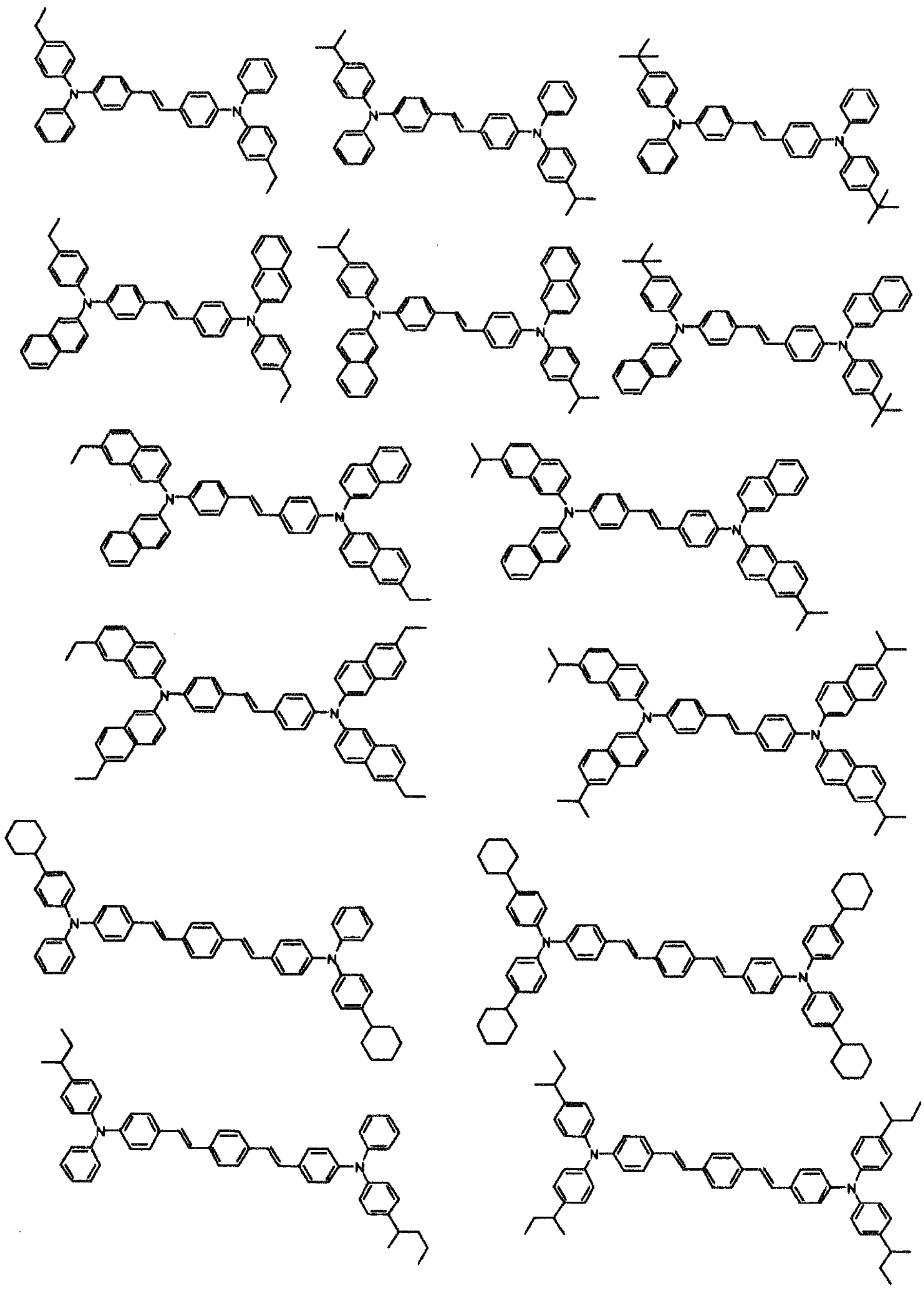

[Formula 44]

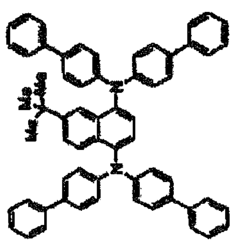
EM126

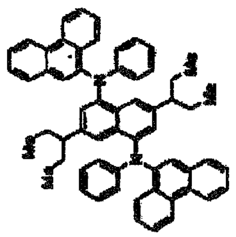
EM127

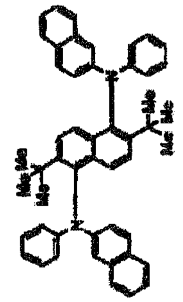
EM128

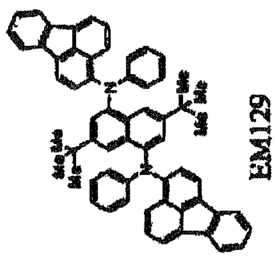
EM129

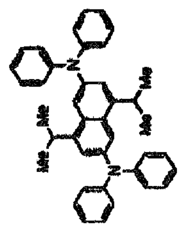
EM130

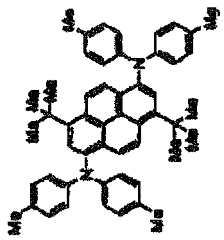
EM131

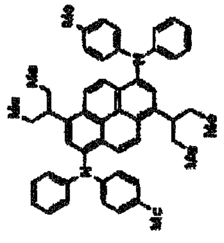
EM132

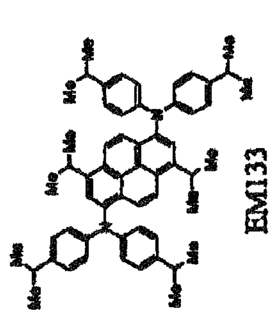
EM133

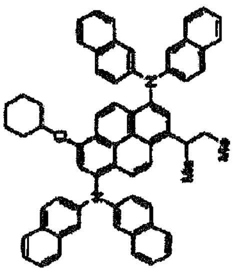
EM134

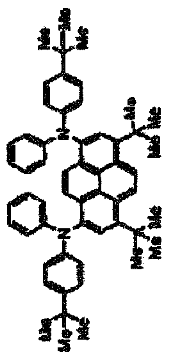
EM135

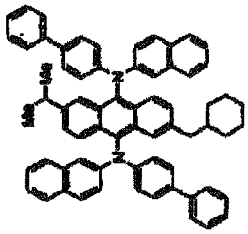
EM136

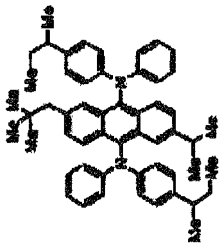
EM137

[Formula 45]

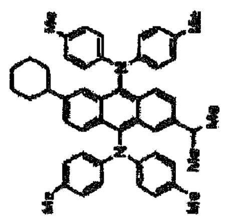
EM138

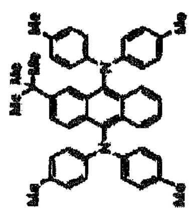
EM139

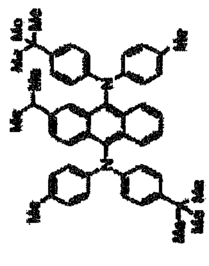
EM140

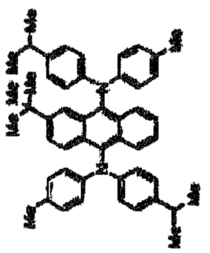
EM141

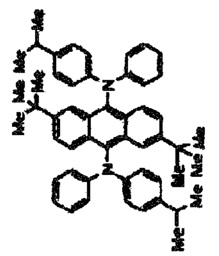
EM142

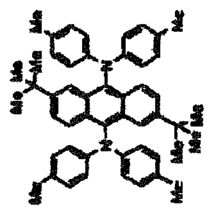
EM143

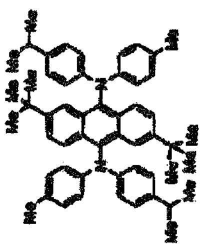
EM144

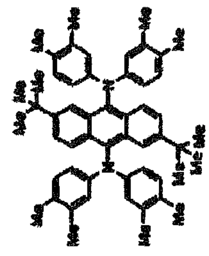
EM145

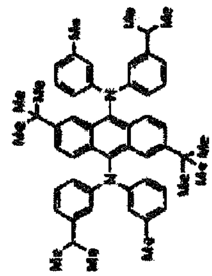
EM146

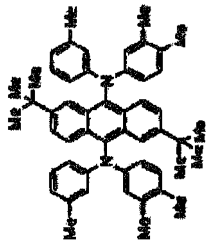
EM147

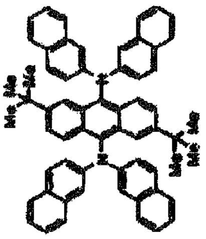
EM148

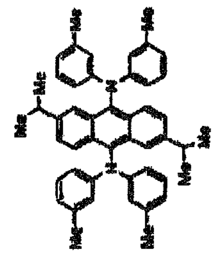
EM149

[Formula 46]

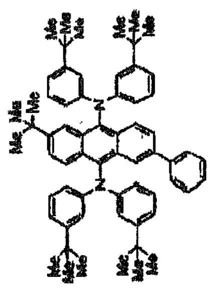

EM153

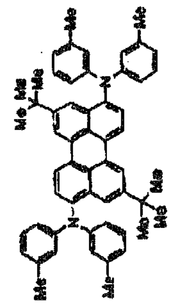

EM157

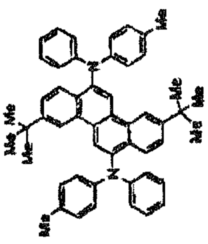

EM161

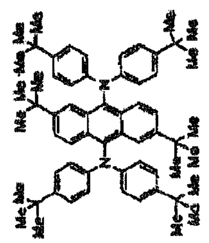

EM152

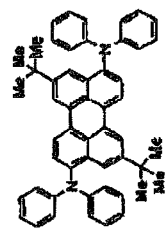

EM156

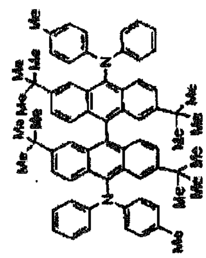

EM160

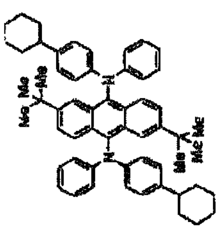

EM151

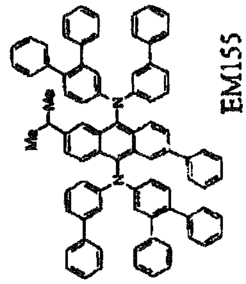

EM155

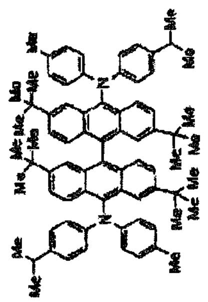

EM159

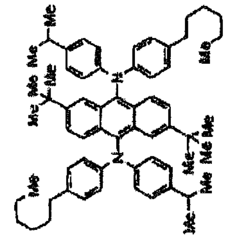

EM150

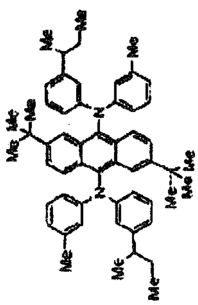

EM154

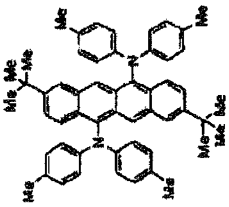

EM158

[Formula 47]

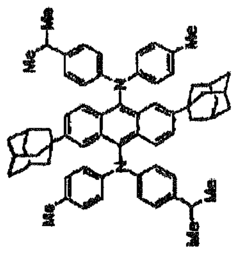

EM165

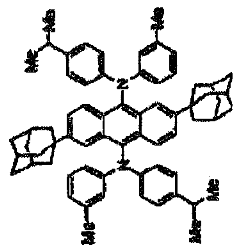

EM164

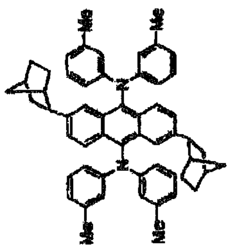

EM163

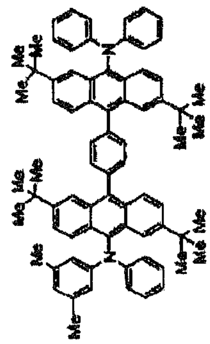

EM162

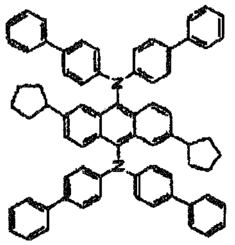

EM168

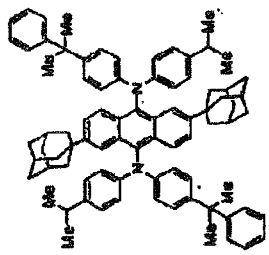

EM167

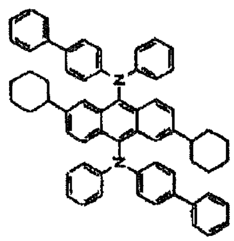

EM166

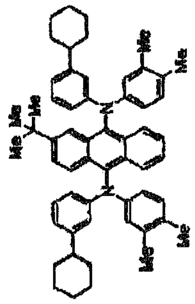

EM172

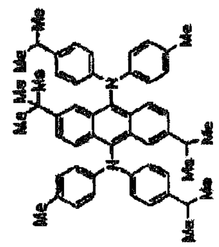

EM171

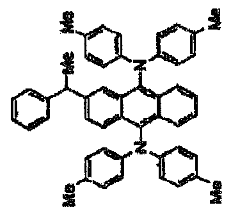

EM170

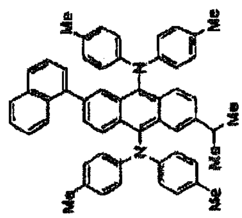

EM169

[Formula 48]

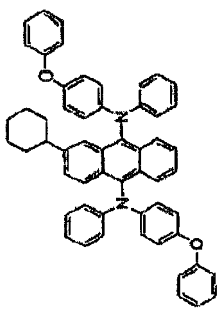

EM173

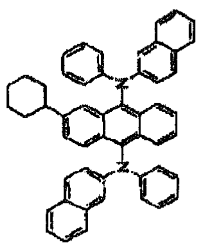

EM174

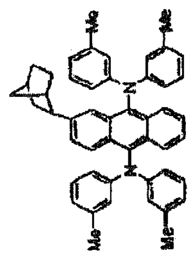

EM175

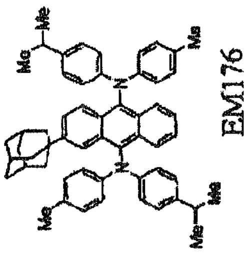

EM176

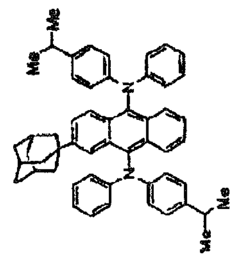

EM177

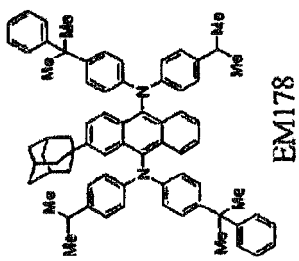

EM178

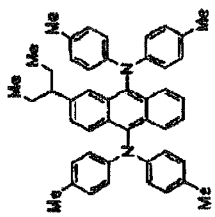

EM179

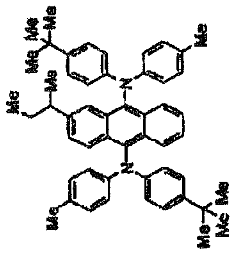

EM180

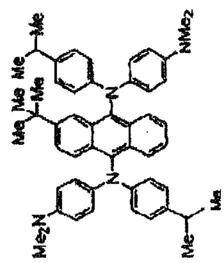

EM181

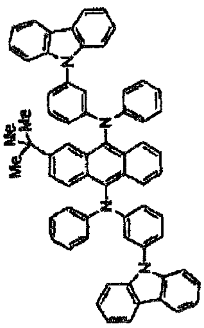

EM182

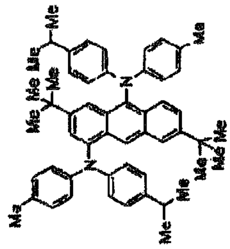

EM183

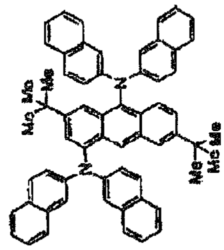

EM184

[Formula 49]

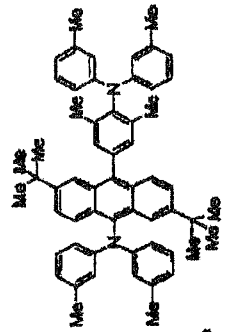

EM188

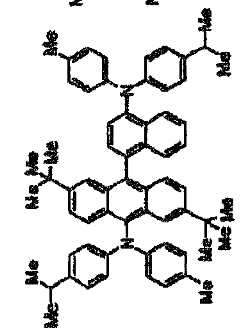

EM187

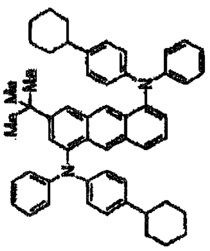

EM186

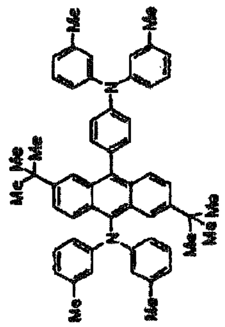

EM190

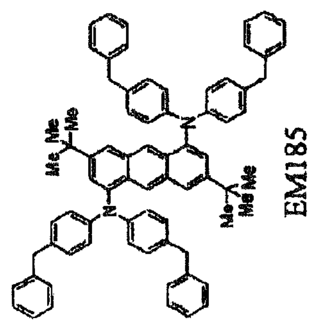

EM185

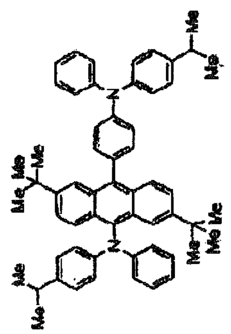

EM189

[Formula 50]

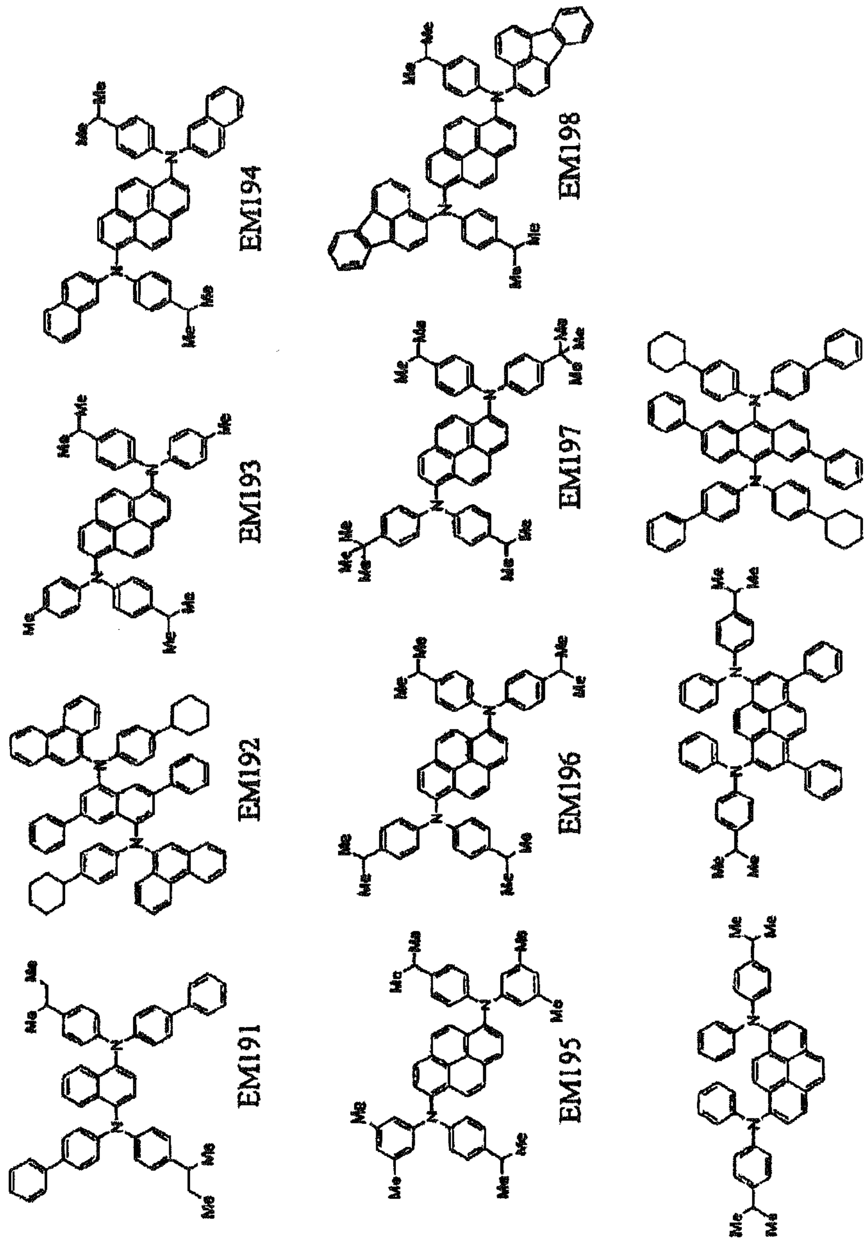

EM191 EM192 EM193 EM194 EM195 EM196 EM197 EM198 EM199 EM200 EM201

[Formula 51]

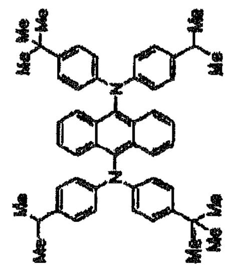
EM205

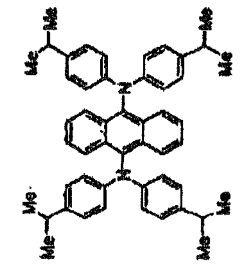
EM204

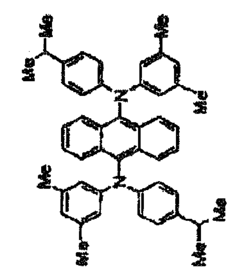
EM203

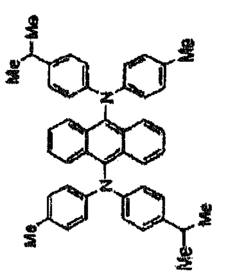
EM202

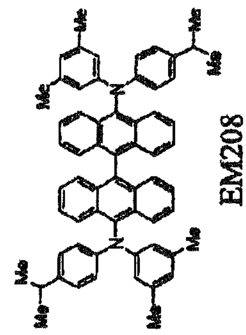
EM208

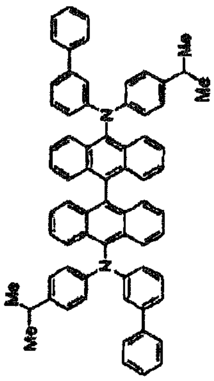
EM207

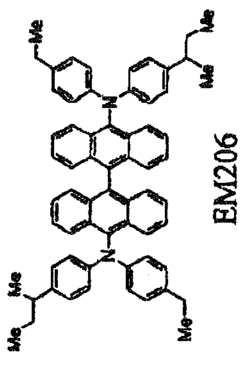
EM206

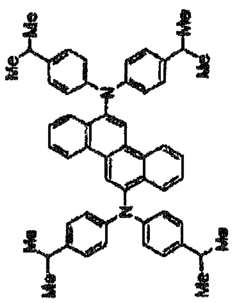
EM212

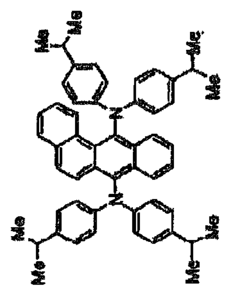
EM211

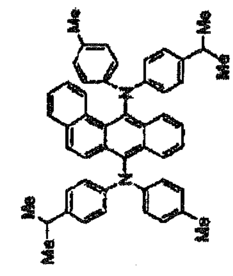
EM210

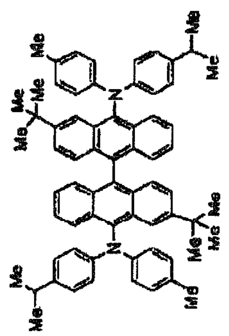
EM209

[Formula 52]

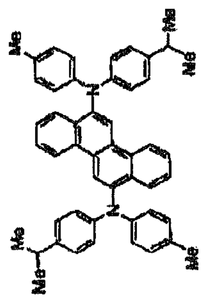
EM213

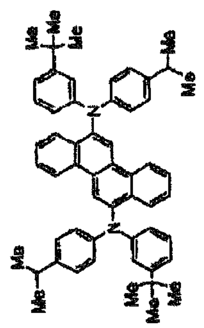
EM214

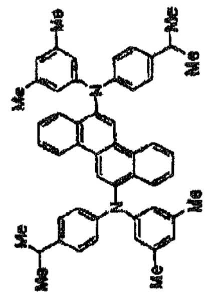
EM215

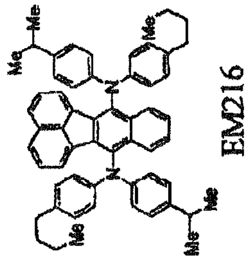
EM216

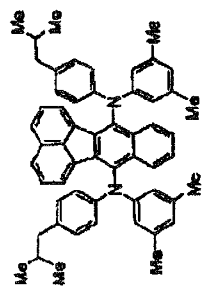
EM217

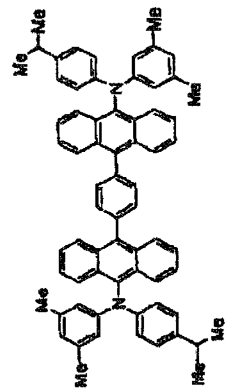
EM218

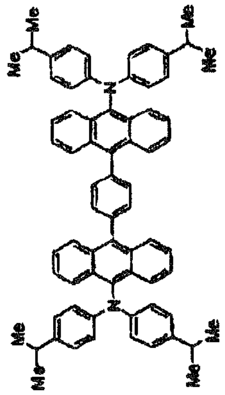
EM219

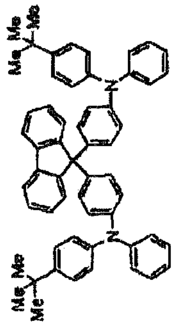
EM220

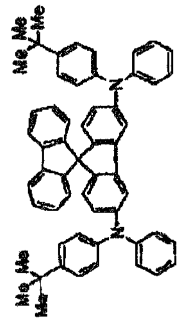
EM221

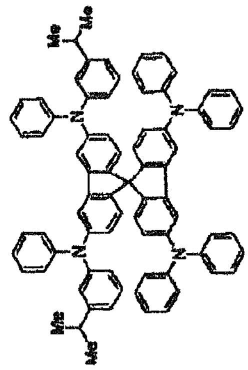
EM222

[Formula 53]

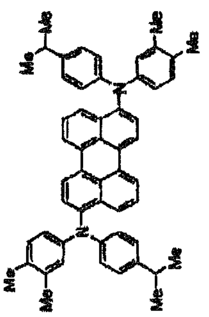
EM223

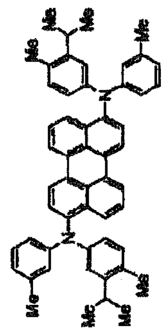
EM224

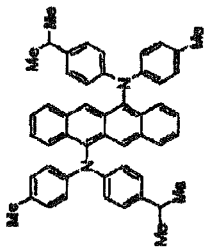
EM225

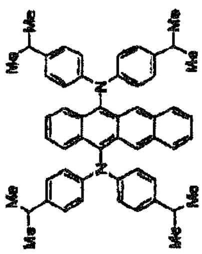
EM226

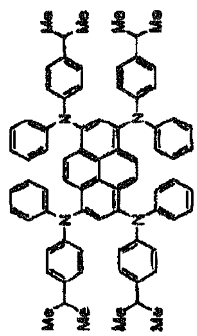
EM227

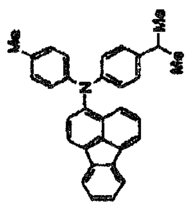
EM228

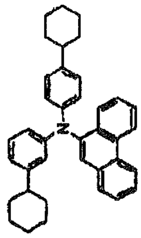
EM229

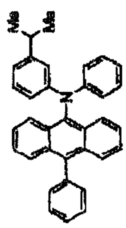
EM230

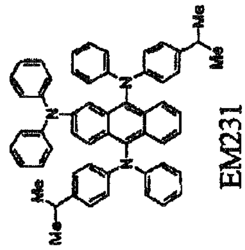
EM231

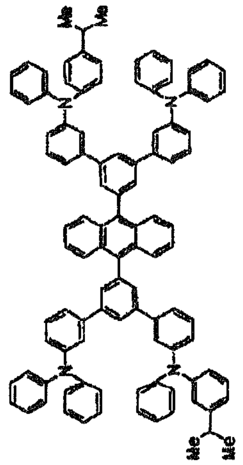
EM232

[Formula 54]

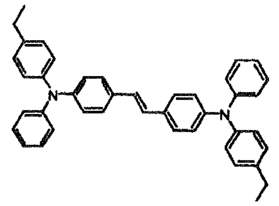
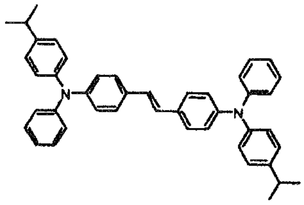
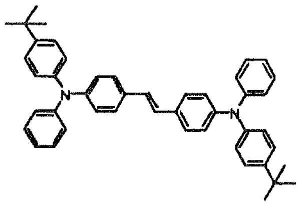

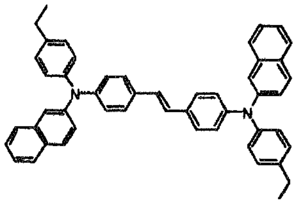
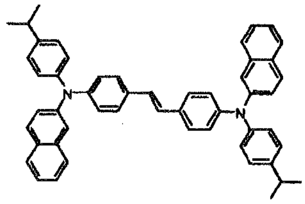
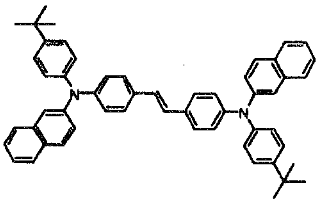

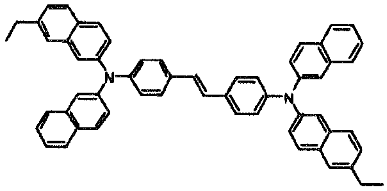
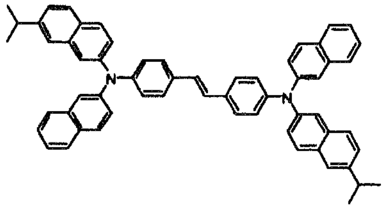

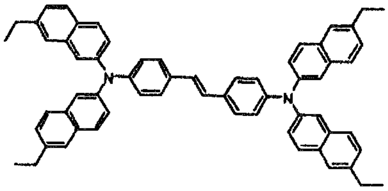
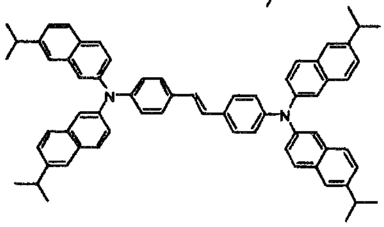

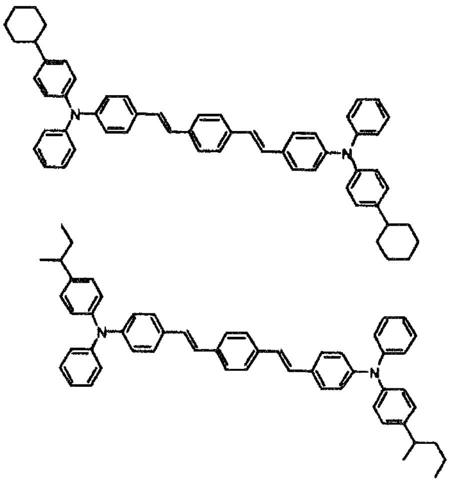
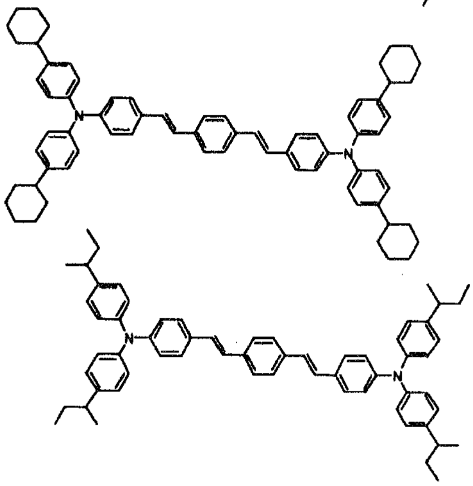

(5) Hole Injecting/Transporting Layers (Hole Transporting Zone)

The hole injecting/transporting layer(s) helps injection of the holes into the emitting layer and transports the holes to an emitting region. In the hole injecting/transporting layer(s), the hole mobility is large while the energy of ionization is typically small (5.5 eV or smaller). A material of the hole injecting/transporting layer(s) is preferably such a material that transports the holes to the emitting layer with a lower field intensity, and more preferably such a material that transports the holes with the hole mobility of at least $10^{-4}$ $cm^2/Vs$ when the exemplary electrical field of $10^4$ to $10^6$ V/cm is applied.

In the organic electroluminescence device according to the present embodiment, the hole injecting layer contains poly(alkylene dioxythiophene) and at least one fluorine-containing colloid-forming polymer acid.
The poly(alkylene dioxythiophene) is poly(3,4-dioxythiophene).

The fluorine-containing colloid-forming polymer acid is a fluorine-containing polymer sulfonic acid, a fluorine-containing polymer carboxylic acid, a fluorine-containing polymer phosphoric acid, a fluorine-containing polymer acrylic acid or a mixture of the above.
The fluorine-containing colloid-forming polymer acid is preferably a perfluorinated polymer acid.

A colloid-forming polymer acid usable in implementing the present invention is insoluble in water. When dispersed in an aqueous medium, the colloid-forming polymer acid forms a colloid. A molecular weight of a polymer acid is typically in a range of approximately 10,000 to approximately 4,000,000. In one embodiment, the molecular weight of a polymer acid is in a range of approximately 100,000 to approximately 2,000,000. A diameter of a colloid particle is typically in a range of 2 nanometer (nm) to approximately 140 nm. In one embodiment, the diameter of a colloid particle is in a range of 2 nm to approximately 30 nm. Any polymer acid may be preferably used in implementing the present invention as long as the polymer acid forms a colloid when dispersed in water. In one embodiment, the colloid-forming polymer acid is a polymer sulfonic acid. Examples of another usable polymer acid are a polymer phosphoric acid, a polymer carboxylic acid and a polymer acrylic acid. Mixtures of the above polymer acids, an example of which is a mixture containing a polymer sulfonic acid, are also usable. In another embodiment, the colloid-forming polymer sulfonic acid is perfluorinated. In a still further embodiment, the colloid-forming polymer sulfonic acid is a perfluoro alkylene sulfonic acid.

In a still further embodiment, the colloid-forming polymer acid is a highly-fluorinated sulfonate polymer (FSA polymer). "highly-fluorinated" means that: at least approximately 50% of the total halogens and hydrogen atoms contained in the polymer are substituted by fluorine atoms; at least approximately 75% thereof are substituted by fluorine atoms in one embodiment; and at least approximately 90% thereof are substituted by fluorine atoms in another embodiment. In one embodiment, the polymer is perfluorinated. A term "sulfonate functional group" herein means either one of a sulfonate group and a salt of a sulfonate group. In one embodiment, the term means either one of an alkali metal and an ammonium salt. The functional group is represented by a formula of $-SO_3X$ (where X represents a cation, which is also known as "counterion"). X may be H, Li, Na, K or $N(R_1)(R_2)(R_3)(R_4)$, in which $R_1$, $R_2$, $R_3$ and $R_4$ may be the same or different from one another. In one embodiment, $R_1$, $R_2$, $R_3$ and $R_4$ are H, $CH_3$ or $C_2H_5$. In another embodiment, X is H. In such an embodiment, the polymer is said to be in an "acid form". In addition, X may be multivalent as represented by an ion such as $Ca^{++}$ and $Al^{+++}$. When a multivalent counterion as generally represented by $Mn^+$ is concerned, a person skilled in the art will clearly understand that the number of sulfonate functional group(s) per counterion is equal to the valence number "n" of the counterion.

In one embodiment, the FSA polymer contains a polymer main chain in which a repeated side chain(s) having a cation-exchange group is bonded to a main chain. The polymer may be a homopolymer or a copolymer of plural monomers. The copolymer is typically formed from a non-functionalized monomer and a second monomer having a cation-exchange group or its precursor such as a sulfonyl fluoride group ($-SO_2F$) that can be subsequently hydrolyzed to sulfonate functional group. For instance, a copolymer of a first fluorinated vinyl monomer and a second fluorinated vinyl monomer having a sulfonyl fluoride group ($-SO_2F$) may be used as the copolymer. Examples of a monomer usable as the first monomer are tetrafluoroethylene (TFE), hexafluoropropylene, fluorinated vinyl, fluorinated vinylidene, trifluoroethylene, chlorotrifluoroethylene, perfluoro(alkyl vinyl ether) and a combination of the above monomers. The first monomer is preferably TFE.

In another embodiment, a monomer usable as the second monomer may be fluorinated vinyl ether having a sulfonate functional group or a precursor group capable of providing a desirable side chain(s) to the polymer. An additional monomer such as ethylene, propylene and $R-CH=CH_2$ (where R is a perfluorinated alkyl group having 1 to 10 carbon atoms) may be added into the above polymers as necessary. The polymer may be a copolymer that is herein called a random copolymer, i.e., a copolymer manufactured by polymerization where a relative concentration of the comonomer is kept as constant as possible so that a distribution of monomer units along the polymer chain consequently corresponds to relative concentrations and relative reactivity of the monomer units. A less random copolymer manufactured by changing the relative concentrations of monomers during polymerization is also usable. Such a polymer as disclosed in Patent Document 2, which is called a block copolymer, is also usable.

According to one embodiment, the FSA polymer to be used in the present invention contains a highly-fluorinated carbon main chain and side chain(s) represented by a formula as follows while the carbon main chain may be perfluorinated in another embodiment:

$$-(O-CF_2CFR_f)_a-O-CF_2CFR'_fSO_3X$$

(In the formula: $R_f$ and $R'_f$ are each selected from a group consisting of F, Cl and a perfluorinated alkyl group having 1 to 10 carbon atoms; "a" is any one of 0, 1 and 2; and X is any one of H, Li, Na, K and $N(R_1(R_2)(R_3)(R_4)$, in which the $R_1$, $R_2$, $R_3$ and $R_4$ may be mutually the same or different, the $R_1$, $R_2$, $R_3$ and $R_4$ being H, $CH_3$ or $C_2H_5$ in one embodiment). In another embodiment, the X is H. As described above, the X may also be multivalent.

In one embodiment, the FSA polymer contains such a polymer as disclosed in US Patent No. 3,282,875, US

Patent No. 4,358,545 and US Patent No. 4,940,525. A preferable example of the FSA polymer contains a perfluorocarbon main chain and a side chain(s) represented by a formula as follows:

$$-O-CF_2CF(CF_3)-O-CF_2CF_2SO_3X$$

(where X is defined as above). The above type of the FSA polymer, which is disclosed in US Patent No. 3,282,875, can be manufactured by: copolymerizing tetrafluoroethylene (TFE) and perfluorinated vinyl ether $CF_2$=CF-O-$CF_2CF(CF_3)$-O-$CF_2CF_2SO_2F$ (perfluoro(3,6-dioxa-4-methyl-7-octene sulfonyl fluoride)) (PDMOF); subsequently converting the sulfonyl fluoride group into a sulfonate group by hydrolysis; and converting the above into desirable ion form by ion exchange as necessary. Such a polymer as disclosed in US Patent No. 4,358,545 and US Patent No. 4,940,525 contains side chain(s) represented by -O-$CF_2CF_2SO_3X$ where X is defined as above. Such a polymer can be manufactured by: copolymerizing tetrafluoroethylene (TFE) and perfluorinated vinyl ether $CF_2$=CF-O-$CF_2CF_2SO_2F$ (perfluoro(3-oxa-4-pentene sulfonyl fluoride)) (POPF); subsequently hydrolyzing the above; and further performing ion exchange as necessary.

In one embodiment, the FSA polymer to be used in the present invention typically has an ion-exchange ratio of less than approximately 33. The "ion-exchange ratio" or "IXR" herein is defined as the number of carbon atoms included in a polymer main chains in relation to a cation-exchange group. IXR may be changed within a range of less than approximately 33 to be suitable for a specific use. IXR is in a range of approximately 3 to 33 in one embodiment while in a range of approximately 8 to 23 in another embodiment.

Cation-exchange capacity of the polymer is frequently represented in equivalent weight (EW). The equivalent weight (EW) herein is defined as a weight of a polymer in an acid form required for neutralizing 1 equivalent weight of sodium hydrate. When a polymer is a sulfonate polymer that has a perfluorocarbon main chain and side chain(s) of -O-$CF_2$-$CF(CF_3)$-O-$CF_2$-$CF_2$-$SO_3H$ (or a salt thereof), the IXR in the range of approximately 8 to 23 corresponds to an equivalent-weight range of approximately 750 to 1500 EW. The IXR of this polymer can be related to the equivalent weight by using a formula of 50 IXR + 344 = EW. Although the same IXR range may be used for, for instance, polymer (s) containing the side chain(s) of -O-$CF_2CF_2SO_3H$ (or a salt thereof) among the sulfonate polymers disclosed in US Patent No. 4,358,545 and US Patent No. 4,940,525, the equivalent weights thereof are lowered by some degree due to lower molecular weights of monomer units containing cation-exchange groups. The preferable IXR range of approximately 8 to 23 corresponds to an equivalent-weight range of approximately 575 to 1325 EW. The IXR of this polymer can be related to the equivalent weight by using a formula of 50 + IXR 178 = EW.

The FSA polymer may be manufactured as a colloidal aqueous dispersion solution. The polymer may be a dispersion solution using another medium. Such medium are exemplarily water-soluble ether such as alcohol and tetrahydrofuran, a mixture of water-soluble ether and combinations thereof but are not limited to the above. In manufacturing a dispersion solution, the polymer may be used in acid form. US Patent No. 4,433,082, US Patent No. 6,150,426 and International Publication No. 03/006537 disclose a manufacturing method of an aqueous alcoholic dispersion solution. After a dispersion solution is manufactured, the concentration of the solution and compositions made therefrom can be adjusted by a method publicly known in the art.

An aqueous dispersion solution of a colloid-forming polymer acid such as the FSA polymer typically forms colloid of as small particle diameter as possible and has as small EW as possible, as long as stable colloid is formed.

An aqueous dispersion solution of the FSA polymer is commercially available as Nafion (Registered Trademark) dispersion solution from E.I. du Pont de Nemours and Company (Wilmington, DE).

(6) Electron Injecting/Transporting Layers (Electron Transporting Zone)

The electron injecting/transporting layer may further be laminated between the organic emitting layer and the cathode. The electron injecting/transporting layer, which helps injection of the electron into the emitting layer, has a high electron mobility.

In the organic electroluminescence device, since emitted light is reflected by an electrode (the cathode, in this case), light directly provided through the anode and the light provided after being reflected by the electrode are known to interfere with each other. In order to efficiently utilize the interference, the thickness of the electron transporting layer is suitably selected from the range of several nanometers to several micrometers. However, especially when the thickness of the layer is large, the electron mobility is preferably at least $10^{-5}$ $cm^2$/Vs or higher so as to prevent voltage rise when the electrical field of $10^4$ to $10^6$ V/cm is applied .

In the organic electroluminescence device according to the present embodiment, the electron transporting layer contains a compound having electron mobility of 1 x $10^{-4}$ to 1 x $10^{-2}$ $cm^2$/Vs at an electric field intensity of 2.5 x $10^5$V/cm. Particularly, the electron transporting layer preferably contains a nitrogen-containing heterocycle derivative represented by the following formula (1).

HAr-L-$Ar^1$-$Ar^2$ (1)

In the above formula (1): HAr represents a substituted or unsubstituted nitrogen-containing heterocycle group having 3 to 40 carbon atoms;
L represents a single bond, a substituted or unsubstituted arylene group having 6 to 60 carbon atoms, a substituted or unsubstituted heteroarylene group having 3 to 60 carbon atoms, or a substituted or unsubstituted fluorenylene group;
$Ar^1$ represents a substituted or unsubstituted divalent aromatic hydrocarbon group having 6 to 60 carbon atoms; and
$Ar^2$ represents a substituted or unsubstituted aryl group having 3 to 60 carbon atoms.
Examples of such a nitrogen-containing heterocycle derivative are shown below. However, the present invention is not limited to exemplification as follows.
[Formula 55]

$HAr-L-Ar^1-Ar^2$

| | HAr | L | $Ar^1$ | $Ar^2$ |
|---|---|---|---|---|
| 1-1 | 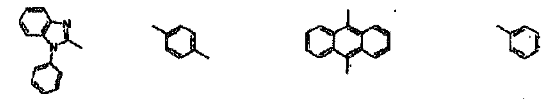 | | | |
| 2 | 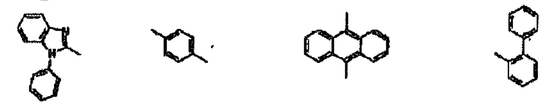 | | | |
| 3 | 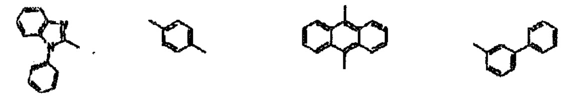 | | | |
| 4 | 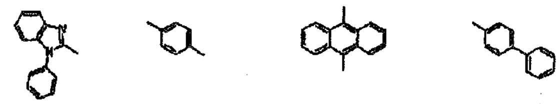 | | | |
| 5 | 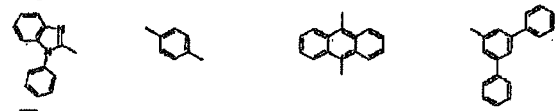 | | | |
| 6 | 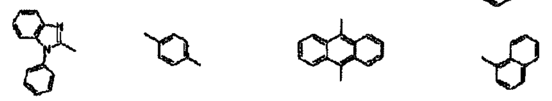 | | | |
| 7 | 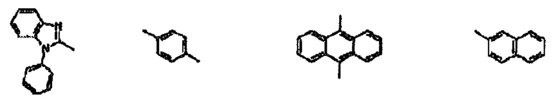 | | | |
| 8 | 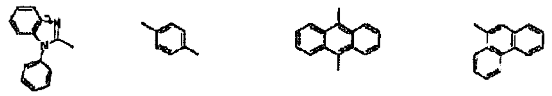 | | | |
| 9 | 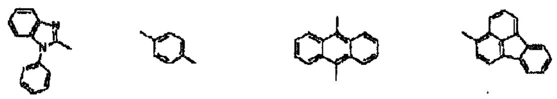 | | | |
| 10 | 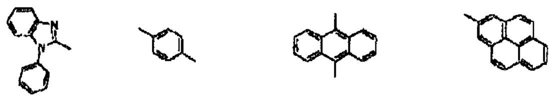 | | | |
| 11 | 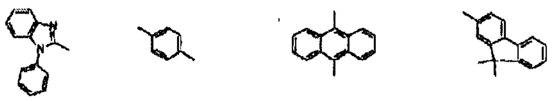 | | | |
| 12 | 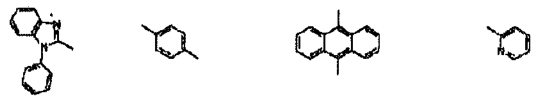 | | | |
| 13 | 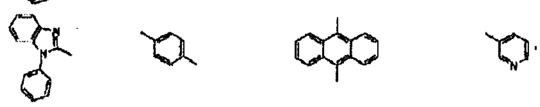 | | | |
| 14 | 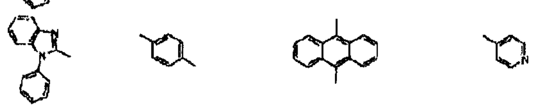 | | | |

[Formula 56]

HAr—L—Ar¹—Ar²

| | HAr | L | Ar¹ | Ar² |
|---|---|---|---|---|
| 2-1 | 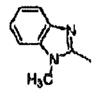 | 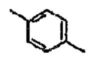 | 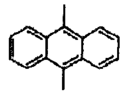 | 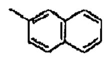 |
| 2 | 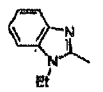 | 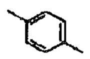 | 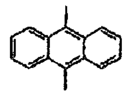 | 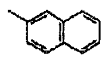 |
| 3 | 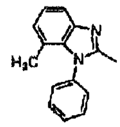 | 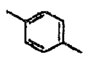 | 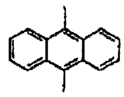 | 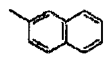 |
| 4 | 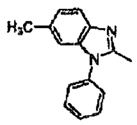 | 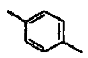 | 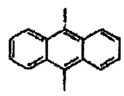 | 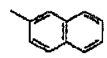 |
| 5 | 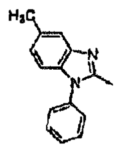 | 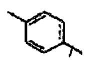 | 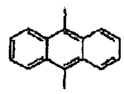 | 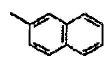 |
| 6 | 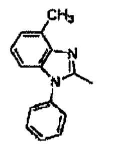 | 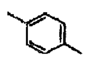 | 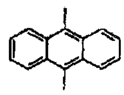 | 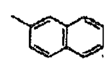 |
| 7 | 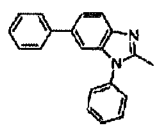 | 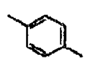 | 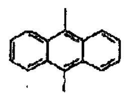 | 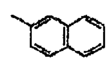 |
| 8 | 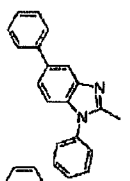 | 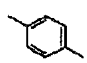 | 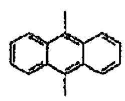 | 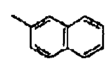 |
| 9 | 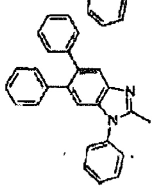 | 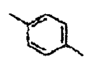 | 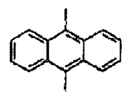 | 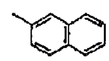 |

[Formula 57]

$HAr—L—Ar^1—Ar^2$

| | HAr | L | $Ar^1$ | $Ar^2$ |
|---|---|---|---|---|
| 3-1 | 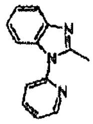 | 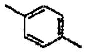 | 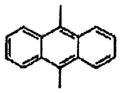 | 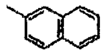 |
| 2 | 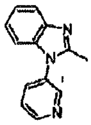 | 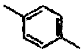 | 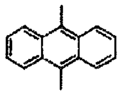 | 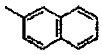 |
| 3 | 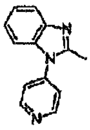 | 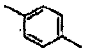 | 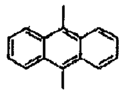 | 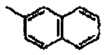 |
| 4 | 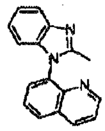 | 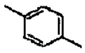 | 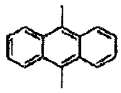 | 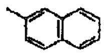 |
| 5 | 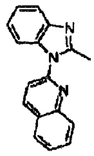 | 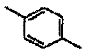 | 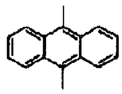 | 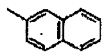 |
| 6 | 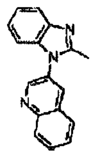 | 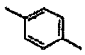 | 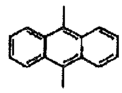 | 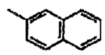 |

[Formula 58]

HAr—L—Ar$^1$—Ar$^2$

HAr L Ar$^1$ Ar$^2$

| | |
|---|---|
| 4-1 | 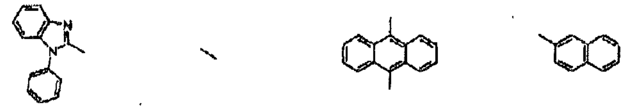 |
| 2 | 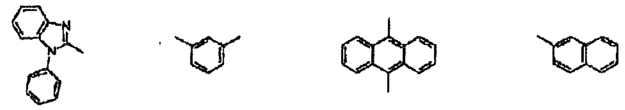 |
| 3 | 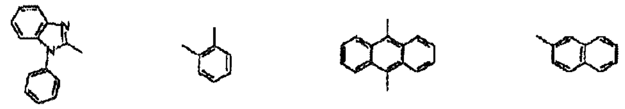 |
| 4 | 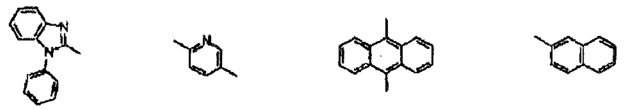 |
| 5 | 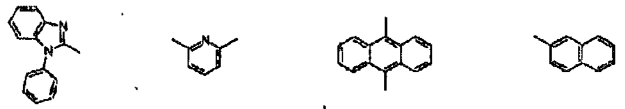 |
| 6 | 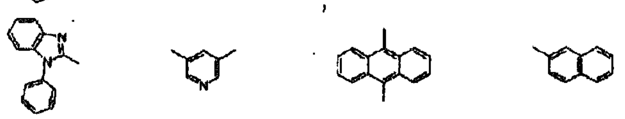 |
| 7 | 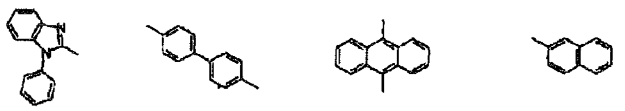 |
| 8 | 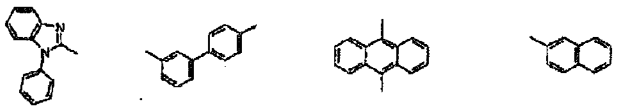 |
| 9 | 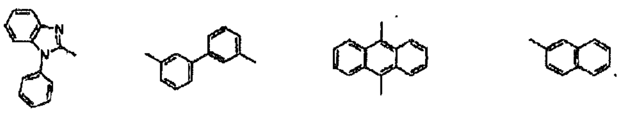 |
| 10 | 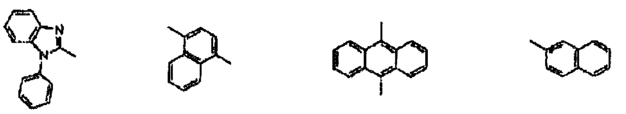 |
| 11 | 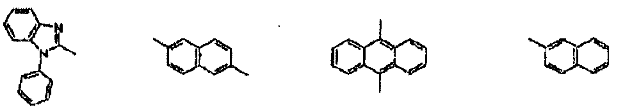 |
| 12 | 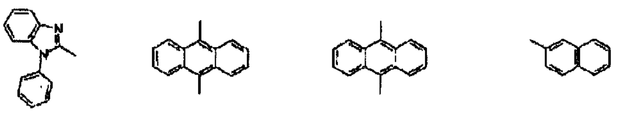 |

[Formula 59]

$HAr-L-Ar^1-Ar^2$

| | HAr | L | $Ar^1$ | $Ar^2$ |
|---|---|---|---|---|
| 5-1 | 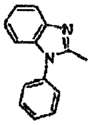 | 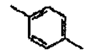 | 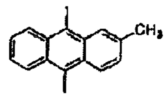 | 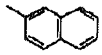 |
| 2 | 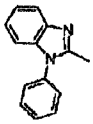 | 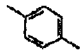 | 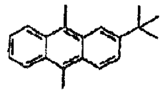 | 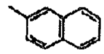 |
| 3 | 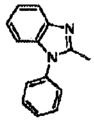 | 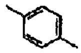 | 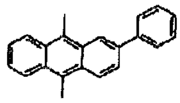 | 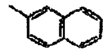 |
| 4 | 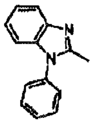 | 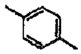 | 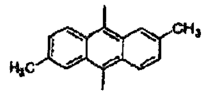 | 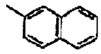 |
| 5 | 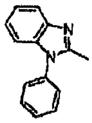 | 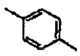 | 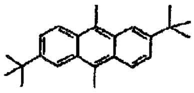 | 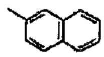 |
| 6 | 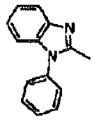 | 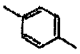 | 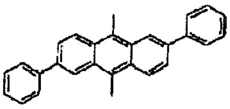 | 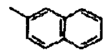 |

[Formula 60]

$HAr—L—Ar^1—Ar^2$

| | HAr | L | $Ar^1$ | $Ar^2$ |
|---|---|---|---|---|
| 6-1 | 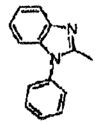 | 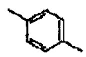 | 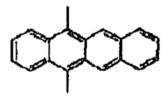 | 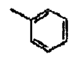 |
| 2 | 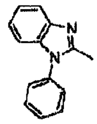 | 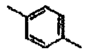 | 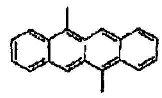 | 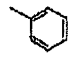 |
| 3 | 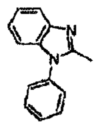 | 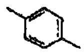 | 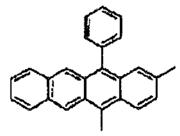 | 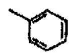 |
| 4 | 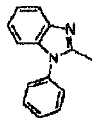 | 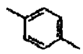 | 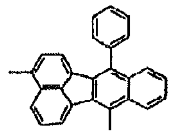 | 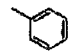 |
| 5 | 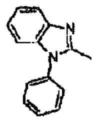 | 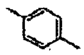 | 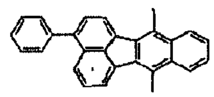 | 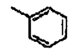 |

[Formula 61]

HAr—L—Ar$^1$—Ar$^2$

| | HAr | L | Ar$^1$ | Ar$^2$ |
|---|---|---|---|---|
| 7-1 | 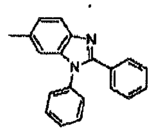 | 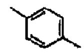 | 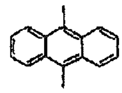 | 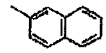 |
| 2 | 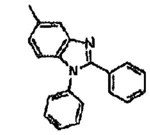 | 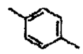 | 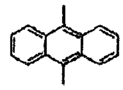 | 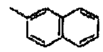 |
| 3 | 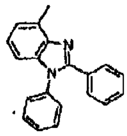 | 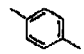 | 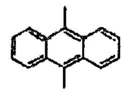 | 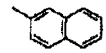 |
| 4 | 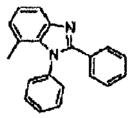 | 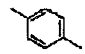 | 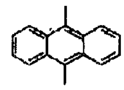 | 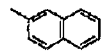 |
| 5 | 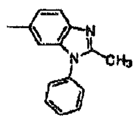 | 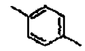 | 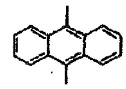 | 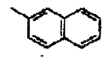 |
| 6 | 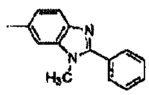 | 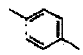 | 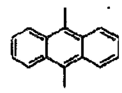 | 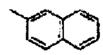 |
| 7 | 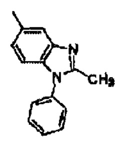 | 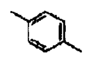 | 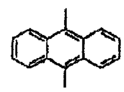 | 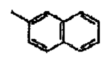 |
| 8 | 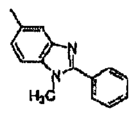 | 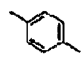 | 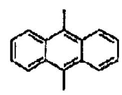 | 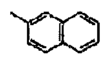 |
| 9 | 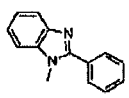 | 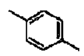 | 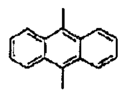 | 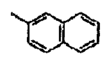 |
| 10 | 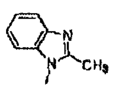 | 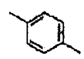 | 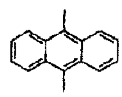 | 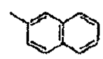 |

[Formula 62]

$$HAr-L-Ar^1-Ar^2$$

| | HAr | L | $Ar^1$ | $Ar^2$ |
|---|---|---|---|---|
| 8-1 | 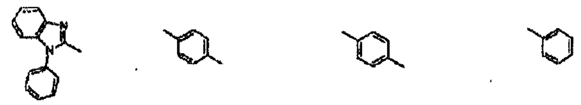 | | | |
| 2 | 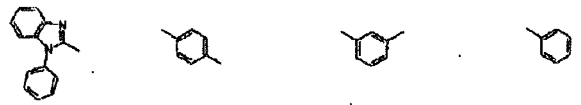 | | | |
| 3 | 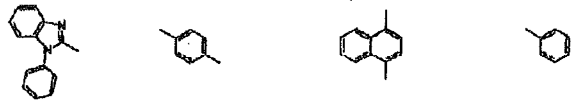 | | | |
| 4 | 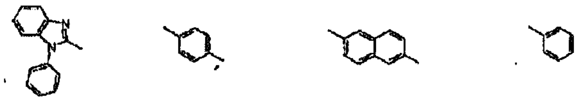 | | | |
| 5 | 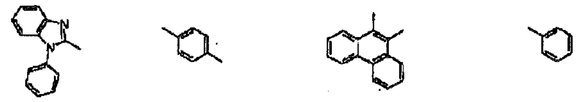 | | | |
| 6 | 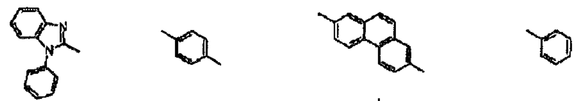 | | | |
| 7 | 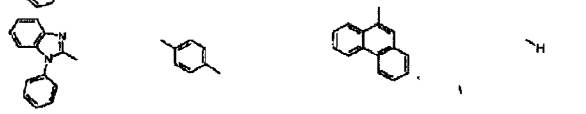 | | | |
| 8 | 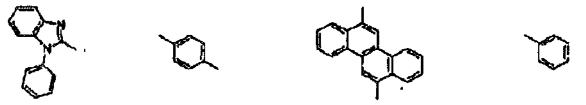 | | | |
| 9 | 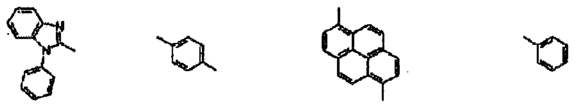 | | | |
| 10 | 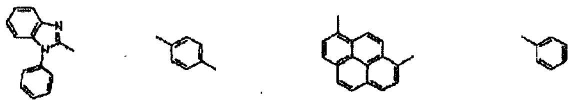 | | | |
| 11 | 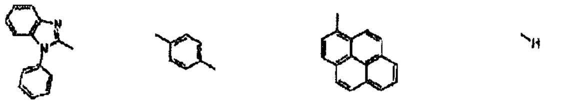 | | | |
| 12 | 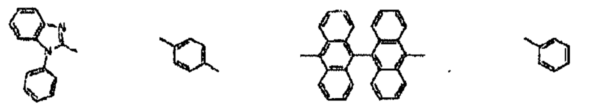 | | | |
| 13 | 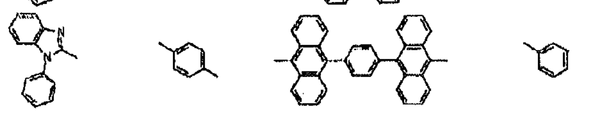 | | | |

[Formula 63]

$HAr-L-Ar^1-Ar^2$

| | HAr / L / $Ar^1$ / $Ar^2$ |
|---|---|
| 9-1 | 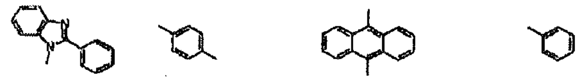 |
| 2 | 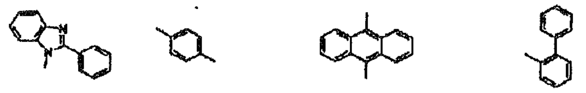 |
| 3 | 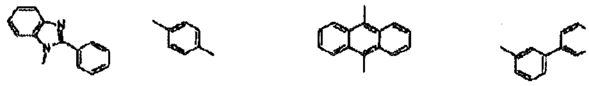 |
| 4 | 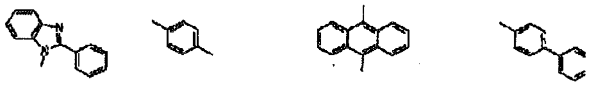 |
| 5 | 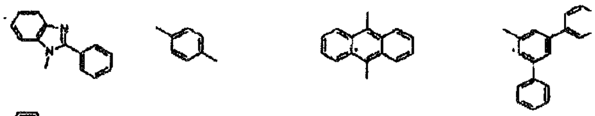 |
| 6 | 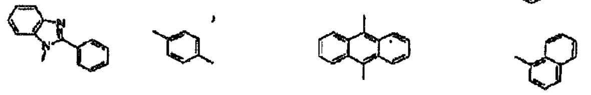 |
| 7 | 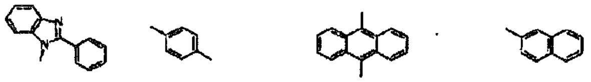 |
| 8 | 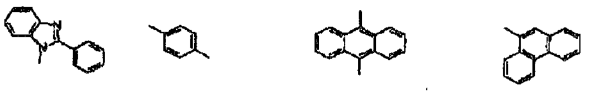 |
| 9 | 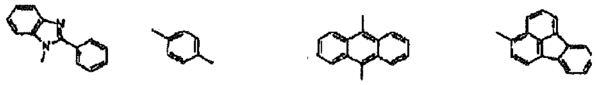 |
| 10 | 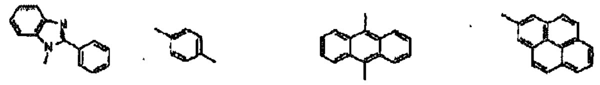 |
| 11 | 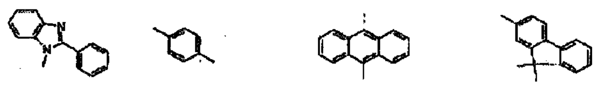 |
| 12 | 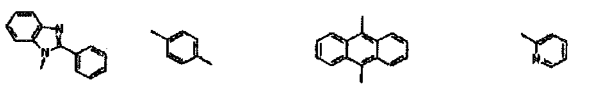 |
| 13 | 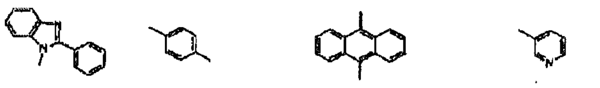 |
| 14 | 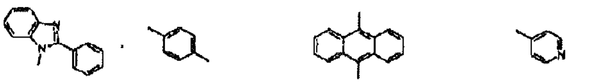 |

[Formula 64]

$HAr-L-Ar^1-Ar^2$

| | HAr | L | $Ar^1$ | $Ar^2$ |
|---|---|---|---|---|
| 10-1 | 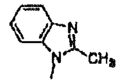 | 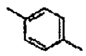 | 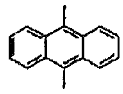 | 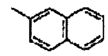 |
| 2 | 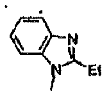 | 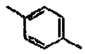 | 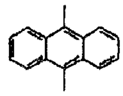 | 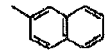 |
| 3 | 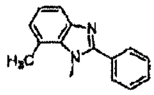 | 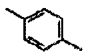 | 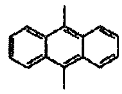 | 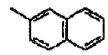 |
| 4 | 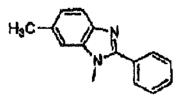 | 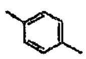 | 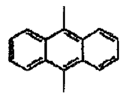 | 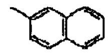 |
| 5 | 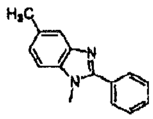 | 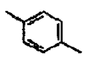 | 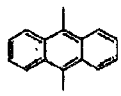 | 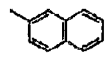 |
| 6 | 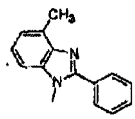 | 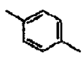 | 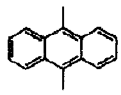 | 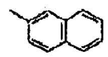 |
| 7 | 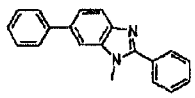 | 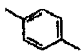 | 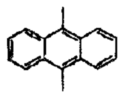 | 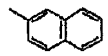 |
| 8 | 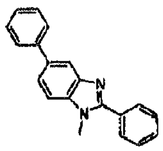 | 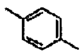 | 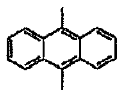 | 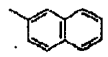 |
| 9 | 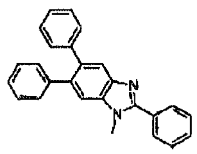 | 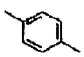 | 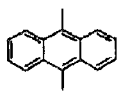 | 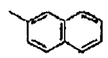 |

[Formula 65]

$HAr-L-Ar^1-Ar^2$

| | HAr | L | $Ar^1$ | $Ar^2$ |
|---|---|---|---|---|
| 11-1 | 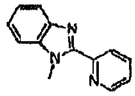 | 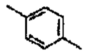 | 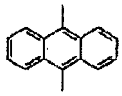 | 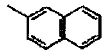 |
| 2 | 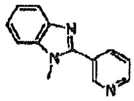 | 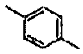 | 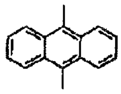 | 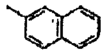 |
| 3 | 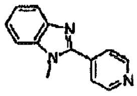 | 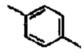 | 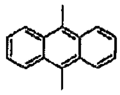 | 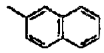 |
| 4 | 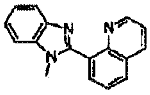 | 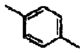 | 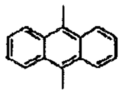 | 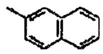 |
| 5 | 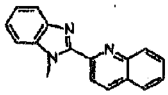 | 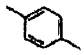 | 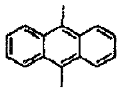 | 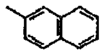 |
| 6 | 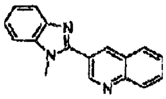 | 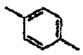 | 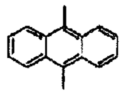 | 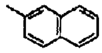 |

[Formula 66]

HAr—L—$Ar^1$—$Ar^2$

| | HAr | L | $Ar^1$ | $Ar^2$ |
|---|---|---|---|---|
| 12-1 | 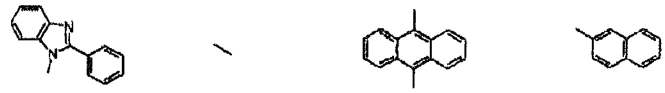 | | | |
| 2 | 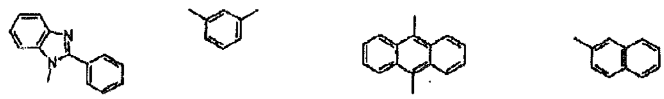 | | | |
| 3 | 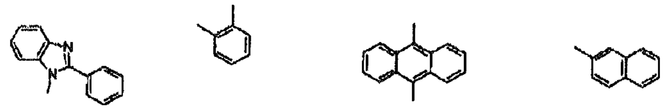 | | | |
| 4 | 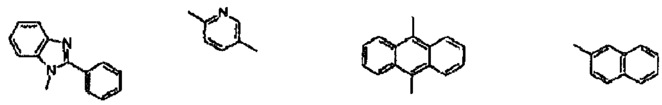 | | | |
| 5 | 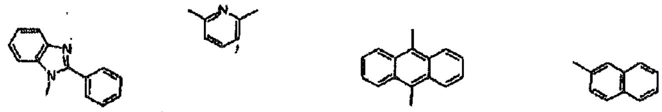 | | | |
| 6 | 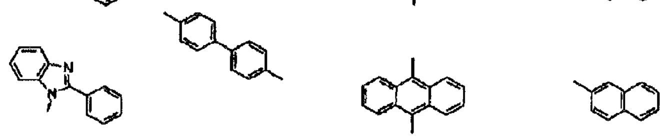 | | | |
| 7 | 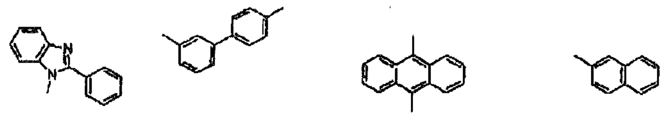 | | | |
| 8 | 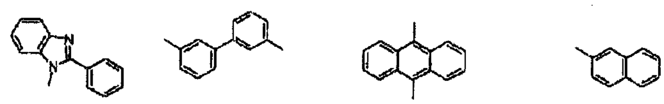 | | | |
| 9 | 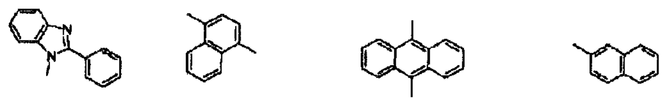 | | | |
| 10 | 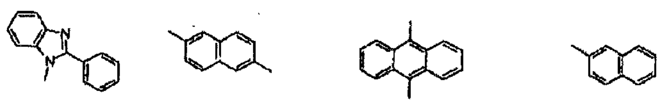 | | | |
| 11 | 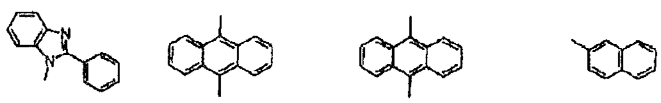 | | | |

[Formula 67]

HAr—L—Ar$^1$—Ar$^2$

| | HAr | L | Ar$^1$ | Ar$^2$ |
|---|---|---|---|---|
| 13-1 | 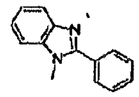 | 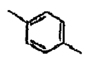 | 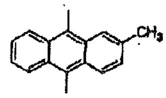 | 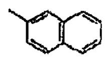 |
| 2 | 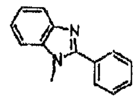 | 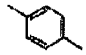 | 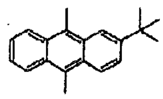 | 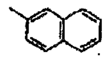 |
| 3 | 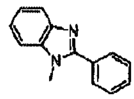 | 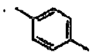 | 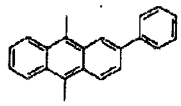 | 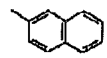 |
| 4 | 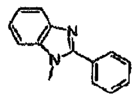 | 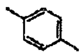 | 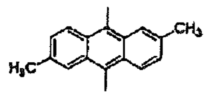 | 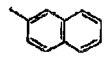 |
| 5 | 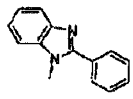 | 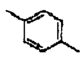 | 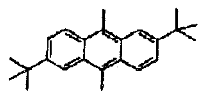 | 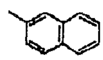 |
| 6 | 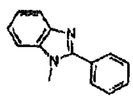 | 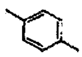 | 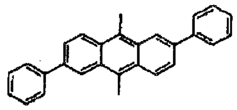 | 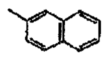 |

[Formula 68]

$HAr-L-Ar^1-Ar^2$

| | HAr | L | $Ar^1$ | $Ar^2$ |
|---|---|---|---|---|
| 14-1 | 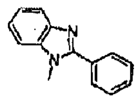 | 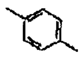 | 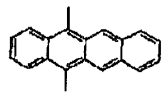 | 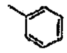 |
| 2 | 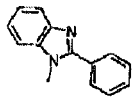 | 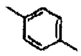 | 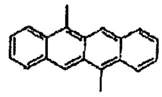 | 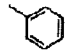 |
| 3 | 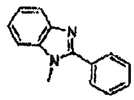 | 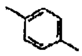 | 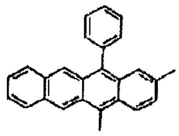 | 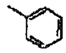 |
| 4 | 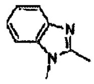 | 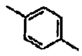 | 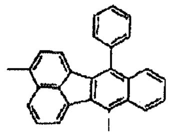 | 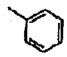 |
| 5 | 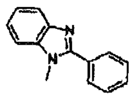 | 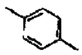 | 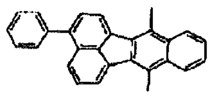 | 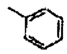 |

[Formula 69]

HAr—L—$Ar^1$—$Ar^2$

| | HAr | L | $Ar^1$ | $Ar^2$ |
|---|---|---|---|---|
| 15-1 | 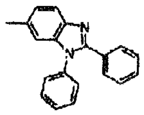 |  | 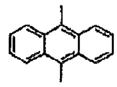 | 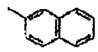 |
| 2 | 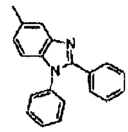 |  | 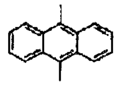 | 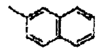 |
| 3 | 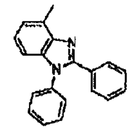 |  | 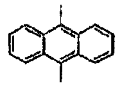 | 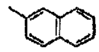 |
| 4 | 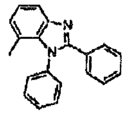 |  | 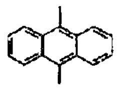 | 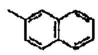 |
| 5 | 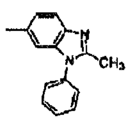 |  | 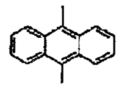 | 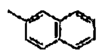 |
| 6 | 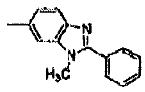 |  | 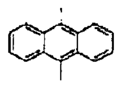 | 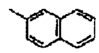 |
| 7 | 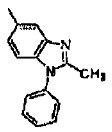 |  | 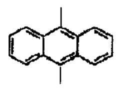 | 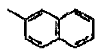 |
| 8 | 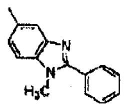 |  | 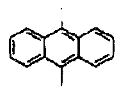 | 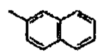 |
| 9 | 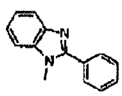 |  | 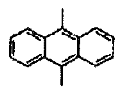 | 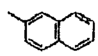 |
| 10 | 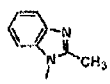 |  | 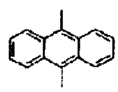 | 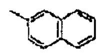 |

[Formula 70]

HAr—L—Ar1—Ar2

| | HAr | L | Ar1 | Ar2 |
|---|---|---|---|---|
| 16-1 | 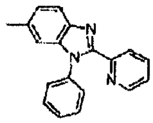 |  | 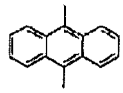 | 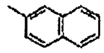 |
| 2 | 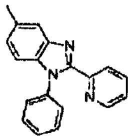 | 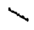 | 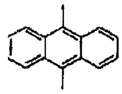 | 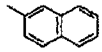 |
| 3 | 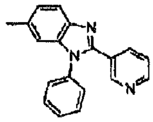 | 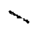 | 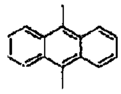 | 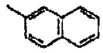 |
| 4 | 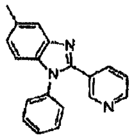 | 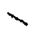 | 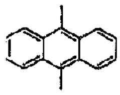 | 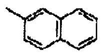 |
| 5 | 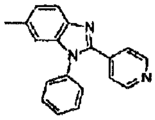 |  | 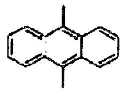 | 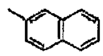 |
| 6 | 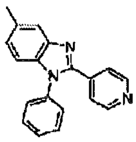 |  | 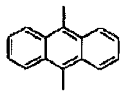 | 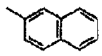 |
| 7 | 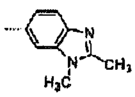 |  | 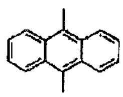 | 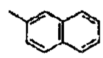 |
| 8 | 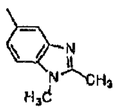 |  | 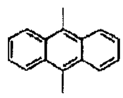 | 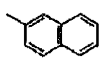 |

[Formula 71]

HAr—L—Ar$^1$—Ar$^2$

| | HAr | L | Ar$^1$ | Ar$^2$ |
|---|---|---|---|---|
| 17-1 | 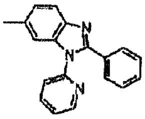 |  | 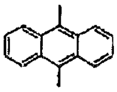 | 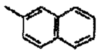 |
| 2 | 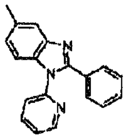 | 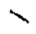 | 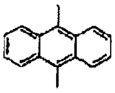 | 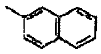 |
| 3 | 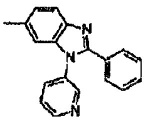 | 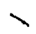 | 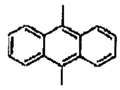 | 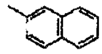 |
| 4 | 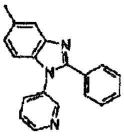 |  | 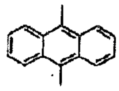 | 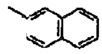 |
| 5 | 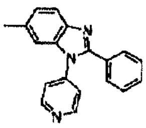 | 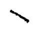 | 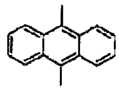 | 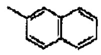 |
| 6 | 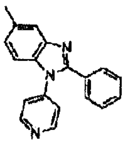 |  | 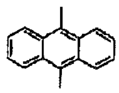 | 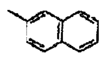 |
| 7 | 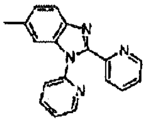 |  | 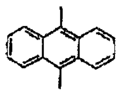 | 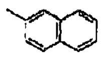 |
| 8 | 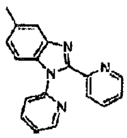 | 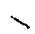 | 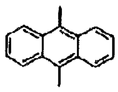 | 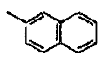 |

Among the above examples, examples (1-1), (1-5), (1-7),(2-1),(3-1),(4-2),(4-6),(7-2),(7-7),(7-8),(7-9) and (9-7) are particularly preferred.

As a preferred embodiment of the organic electroluminescence device, there is known a device containing a reductive dopant at a boundary between a region transporting the electron or the cathode and an organic layer. Here, the reductive dopant is defined as a substance capable of reducing an electron transporting compound. Thus, various substances having a certain level of reducibility can be used, preferable examples of which are at least one substance selected from a group consisting of: alkali metal, an oxide of the alkali metal, a halogenide of the alkali metal, an organic complex of the alkali metal, alkali earth metal, an oxide of the alkali earth metal, a halogenide of the alkali earth metal, an organic complex of the alkali earth metal, rare earth metal, an oxide of the rare earth metal, a halogenide of the rare earth metal and an organic complex of the rare earth metal.

Specifically, reductive dopant is preferably a substance(s) having the work function of 2.9 eV or lower, which is exemplified by at least one alkali metal selected from a group consisting of Li (work function: 2.9 eV), Na (work function:

2.36 eV), K (work function: 2.28 eV), Rb (work function: 2.16 eV) and Cs (work function: 1.95 eV) or at least one alkali earth metal selected from a group consisting of Ca (work function: 2.9 eV), Sr (work function: 2 to 2.5 eV) and Ba (work function: 2.52 eV), and the substances having the work function of 2.9 eV or lower are particularly preferable. Among these, more preferable reductive dopant is at least one alkali metal selected from a group consisting of K, Rb and Cs, in which Rb and Cs are even more preferable and Cs is the most preferable. These alkali metals have particularly high reducibility, so that addition of a relatively small amount of these alkali metals to an electron injecting zone can enhance luminescence intensity and lifecycle of the organic electroluminescence device. In addition, as the reductive dopant having the work function of 2.9 eV or lower, a combination of two or more of these alkali metals is also preferable, and a combination including Cs is particularly preferable (e.g. combinations of Cs and Na, Cs and K, Cs and Rb or Cs, Na and K). The combinations including Cs can effectively exert the reducibility, so that the addition of such reductive dopant to the electron injecting zone can enhance the luminescence intensity and the lifecycle of the organic electroluminescence device.

An electron injecting layer formed from an insulator or a semiconductor may be provided between the cathode and the organic layer. With the arrangement, leak of electric current can be effectively prevented and the electron injecting capability can be enhanced. As the insulator, it is preferable to use at least one metal compound selected from a group consisting of an alkali metal chalcogenide, an alkali earth metal chalcogenide, a halogenide of alkali metal and a halogenide of alkali earth metal. By forming the electron injecting layer from the alkali metal chalcogenide or the like, the electron injecting capability can preferably be further enhanced. Specifically, preferable examples of the alkali metal chalcogenide are $Li_2O$, $K_2O$, $Na_2S$, $Na_2Se$ and $Na_2O$, while preferable example of the alkali earth metal chalcogenide are CaO, BaO, SrO, BeO, BaS and CaSe. Preferable examples of the halogenide of the alkali metal are LiF, NaF, KF, LiCl, KCl and NaCl. Preferable examples of the halogenide of the alkali earth metal are fluorides such as $CaF_2$, $BaF_2$, $SrF_2$, $MgF_2$ and $BeF_2$, and halogenides other than the fluoride.
Examples of the semiconductor for forming the electron transporting layer are one of or a combination of two or more of an oxide, a nitride or an oxidized nitride containing at least one element selected from a group consisting of Ba, Ca, Sr, Yb, Al, Ga, In, Li, Na, Cd, Mg, Si, Ta, Sb and Zn. An inorganic compound for forming the electron transporting layer is preferably a microcrystalline or amorphous semiconductor film. When the electron transporting layer is formed of such semiconductor film, more uniform thin film can be formed, thereby reducing pixel defects such as a dark spot. Examples of such an inorganic compound are the above-described alkali metal chalcogenide, alkali earth metal chalcogenide, halogenide of the alkali metal and halogenide of the alkali earth metal.

(7) Cathode

In order to inject the electrons into the electron inj ecting/transporting layer or the emitting layer, a material whose work function is small (4 eV or lower) is used as an electrode material for the cathode, examples of the material being metals, alloys, electrically conductive compounds and mixtures thereof. Examples of the electrode material are sodium, a sodium-potassium alloy, magnesium, lithium, a magnesium-silver alloy, aluminium/aluminium oxide, an aluminium-lithium alloy, indium, rare earth metal and the like.
The cathode may be made by forming a thin film from the electrode material by vapor deposition and sputtering.
When luminescence from the emitting layer is provided through the cathode, the cathode preferably transmits more than 10% of the luminescence.
The sheet resistance as the cathode is preferably several hundreds Ω/ square or lower, and the thickness of the film is typically in a range from 10 nm to 1 μm, preferably 50 to 200 nm.

(8) Insulating Layer

Since the electrical field is applied to ultra thin films in the organic electroluminescence device, pixel defects resulted from leak or short circuit are likely to occur. In order to prevent such defects, it is preferable to interpose an insulating thin film layer between a pair of electrodes.
Examples of a material used for the insulating layer are aluminum oxide, lithium fluoride, lithium oxide, cesium fluoride, cesium oxide, magnesium oxide, magnesium fluoride, calcium oxide, calcium fluoride, aluminium nitride, titanium oxide, silicon oxide, germanium oxide, silicon nitride, boron nitride, molybdenum oxide, ruthenium oxide, vanadium oxide and the like.
Mixtures or laminates thereof may also be used.

(9) Manufacturing Method of Organic Electroluminescence Device

The organic electroluminescence device can be manufactured by forming the anode, the emitting layer, the hole injecting layer (as necessary), the electron injecting layer (as necessary) and the cathode form the materials listed

above by the above-described formation methods. The organic electroluminescence device can also be manufactured by forming the above elements in the inverse order of the above, namely from the cathode to the anode.

The following is an example of a manufacturing method of the organic electroluminescence device in which the anode, the hole injecting layer, the emitting layer, the electron injecting layer and the cathode are sequentially formed on the light-transmissive substrate.

A thin film is formed of the anode material on a suitable light-transmissive substrate by vapor deposition or sputtering such that the thickness of the thin film is 1 μm or smaller, preferably in a range from 10 nm to 200 nm, thereby forming the anode.

Then, the hole injecting layer is formed on the formed anode.

The hole injecting layer can be formed by vacuum deposition, spin coating, casting method, LB method or the like. The thickness of the hole injecting layer is suitably determined within a range of 5 nm to 5 μm.

Then, the emitting layer is formed on the hole injecting layer by forming a thin film from an organic luminescent material by a dry process represented by the vacuum deposition or a wet process such as spin coating and casting method.

Then, the electron injecting layer is formed on the emitting layer.

The electron injecting layer may be exemplarily formed by vacuum deposition.

Lastly, the cathode is laminated on the electron injecting layer, whereby the organic electroluminescence device can be obtained.

The cathode can be formed from a metal by a method such as vapor deposition and sputtering.

In order to protect the organic layers deposited under the cathode from being damaged, the vacuum deposition is preferable.

The methods for forming each of the layers in the organic electroluminescence device are not particularly limited. Conventional methods such as vacuum deposition and spin coating can be employed for forming the organic film layers. Specifically, the organic film layers may be formed by a conventional coating method such as vacuum deposition, molecular beam epitaxy (MBE method) and coating methods using a solution such as a dipping, spin coating, casting, bar coating, roll coating and ink jet printing.

Although the thickness of each organic layer of the organic electroluminescence device is not particularly limited, the thickness is generally preferably in a range of several nanometers to 1 μm because excessively-thinned film likely entails defects such as a pin hole while excessively-thickened film requires high voltage to be applied and deteriorates efficiency.

When a direct current is applied to the organic electroluminescence device, the luminescence can be observed by applying a voltage of 5 to 40V with the anode having the positive polarity and the cathode having the negative polarity. When the voltage is applied with the inversed polarity, no current flows, so that the luminescence is not generated. When an alternating current is applied, the uniform luminescence can be observed only when the anode has the positive polarity and the cathode has the negative polarity. A waveform of the alternating current to be applied may be suitably selected.

[Example]

Example(s) of the present invention will be described.

(Measurement of Electron Mobility)

Electron mobility was measured with a time-of-flight measuring machine TOF-401 manufactured by Sumitomo Heavy Industries Advanced Machinery.

Using a translucent metal electrode (Al: 10nm) as the anode while using a transparent oxide electrode (ITO: 130nm) as the cathode, a sample was laminated on the machine by 3 μm so as to measure the mobility. The ITO substrate used as the cathode was cleaned in the same manner as in later-described Example 1. In addition, each material was laminated by vapor deposition as in Example 1.

The sample was set on a sample chamber of the time-of-flight measuring machine TOF-401, and the sample was connected to the anode and the cathode both by a gold-coated probe. Signal current was detected by observing terminal voltages of parallelly-connected load resistors with an oscilloscope.

Observation of the signal current is conducted simultaneously with irradiation of laser beam. The current is decreased after some time has lapsed. The decrease in the current means that a sheet of electrons has reached the anode. The inflection time (movement time) is represented by $t_T$.

Electron mobility $\mu_e$ is defined as in a following formula.

$$\mu_e = d / t_T \times E$$

In the formula, "d" represents a film thickness of the sample while E represents an electric field intensity.
In general, the electron mobility depends on the electric field intensity. When the mobility is plotted with the square root of the electric field intensity, a linear shape is frequently observed. Accordingly, when the mobility is defined as a numeric value, conditions of the electric field intensity should be specified when the mobility is measured. A value when the electric field intensity was 2.5 x $10^5$ (V/cm) was used as the value of the mobility ($cm^2/Vs$) herein.

(Manufacturing of Hole Injecting Material)

40g of a poly(3,4-ethylenedioxithiophene)/ polystyrene sulfonate solution with a concentration of 1.32% (manufactured by H.C. StarckGmbH, product name: Baytron™ P, TPAI4083, in which a mass ratio of PEDOT to PSS was 1: 6) was mixed with 9.96g of a solution prepared by dissolving Nafion™ in a mixture of lower aliphatic alcohol and water with a concentration of 5.30 mass% (a solution in which Nafion™ perfluorinated ion-exchange resin was dissolved in a mixture of lower aliphatic alcohol/$H_2O$ with a concentration of 5 mass%, CAS-No. 66796-30-3, Aldrich order No. 27,470-4, a verified solid content of 5.30 mass%). The mass ratio between PEDOT, PSS and Nafion™ was 1: 6: 7.

(Example 1)

A glass substrate (size: 25 mm x 75 mm x 1.1 mm thick) having an ITO transparent electrode (manufactured by Geomatics) was ultrasonic-cleaned in isopropyl alcohol for five minutes, and then UV/ozone-cleaned for 30 minutes. A mixture of PEDOT and Nafion™ prepared as described above was applied on the substrate by spin coating to form a film of 50 nm. The layer serves as the hole injecting layer.
N,N,N',N'-tetra(4-biphenyl)-diamine biphenylene (hereinafter called, "TBDB layer") was deposited on the layer by vacuum deposition to form a film of 20nm. The layer serves as the hole transporting layer.
Then, the compounds AN-1 and BD-1 (mass ratio of AN-1 to BD-1 was 20: 1) were simultaneously deposited thereon to form an emitting layer of 40nm thickness.
An electron transporting material (ET-1, electron mobility: 1.1 x $10^{-4}$ $cm^2/Vs$, hereinafter abbreviated as "ET film") was deposited on the film to form a film of 20nm thickness. The ET film serves as the electron transporting layer.
Subsequently, LiF was deposited thereon to form a film of 1nm thickness, such that 150nm thick Al was deposited on the LiF film to form a metal cathode, thereby providing an organic electroluminescence device. Luminous efficiency, voltage and chromaticity at 10mA/$cm^2$ of the obtained organic electroluminescence device were measured. In addition, a room temperature when the initial luminescence intensity was 5000cd/$m^2$ and time elapsed until a half-life of the luminescence intensity when the device was driven by DC constant current were measured.
[Formula 72]

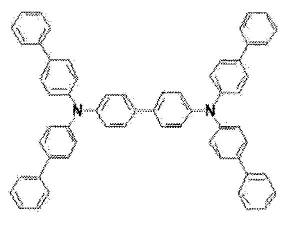
TBDT

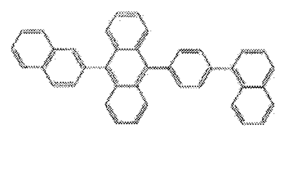
AN1

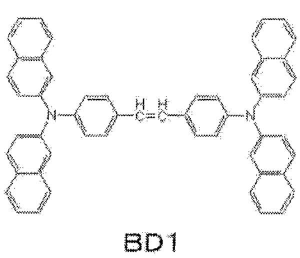
BD1

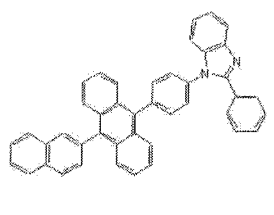
ET1

(Comparative 1)

In place of the mixture of PEDOT and Nafion™ described in the above Example 1, copper phthalocyanine (CuPc) was deposited to form a film of 100nm, and in place of the electron transporting material (ET), an aluminum quinolinol complex (Alq3, electron mobility: 5 x $10^{-6}$ $cm^2$/Vs) was deposited to form a film of 20nm.

(Comparative 2)

In place of the electron transporting material (ET-1) described in the above Example 1, an aluminum quinolinol complex (Alq3) was deposited to form a film of 20nm.

(Comparative 3)

In place of the mixture of PEDOT and Nafion™ described in the above Example 1, copper phthalocyanine (CuPc) was deposited to form a film of 50nm.

(Comparative 4)

In place of the mixture of PEDOT and Nafion™ described in the above Example 1, PEDOT-PSS was deposited to form a film of 50nm.

(Comparative 5)

In place of the compounds AN-1 and BD-1 described in the above Example 1, compounds RH and RD as follows (weight ratio of RH: RD = 40: 0.4) were deposited to form an emitting layer of 40nm thickness.
[Formula 73]

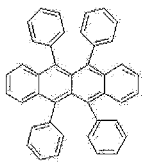

RH

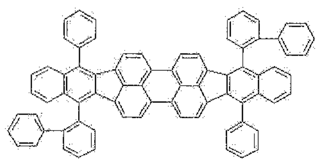

RD

(Comparative 6)

In place of the mixture of REDOT and Nafion™ described in the above Example 1, PEDOT-PSS was deposited to form a film of 50nm, and in place of the compounds AN-1 and BD-1, the compounds RH and RD (weight ratio of RH: RD = 40: 0.4) were deposited to form an emitting layer of 40nm thickness.
Evaluation results of the Example 1 and Comparatives 1 to 6 are shown in Table 1.
[Table 1]

| | Hole Injecting Layer | Emitting Layer | Electron Transporting Layer | Voltage | Efficiency | Chromaticity | Lifetime |
|---|---|---|---|---|---|---|---|
| | | | | (V) | (cd/A) | (x,y) | (h) |
| Example 1 | PEDOT: PSS: Nafion™ | AN-1:BD-1 | ET1 | 5.5 | 6.0 | (0.14, 0.18) | 500 |
| Comparative 1 | CuPc | AN-1: BD-1 | Alq | 8.0 | 4.4 | (0.14, 0.17) | 300 |

(continued)

| | Hole Injecting Layer | Emitting Layer | Electron Transporting Layer | Voltage | Efficiency | Chromaticity | Lifetime |
|---|---|---|---|---|---|---|---|
| | | | | (V) | (cd/A) | (x,y) | (h) |
| Comparative 2 | PEDOT: PSS: Nafion™ | AN-1:BD-1 | Alq | 6.5 | 4.8 | (0.14, 0.20) | 300 |
| Comparative 3 | CuPc | AN-1: BD-1 | ET1 | 6.0 | 4.9 | (0.14, 0.17) | 100 |
| Comparative 4 | PEDOT:PSS | AN-1: BD-1 | ET1 | 5.9 | 4.6 | (0.14, 0.18) | 350 |
| Comparative 5 | PEDOT: PSS: Nafion™ | RH:RD | Alq | 4.9 | 7.4 | (0.65, 0.35) | |
| Comparative 6 | PEDOT:PSS | RH:RD | Alq | 5.1 | 6.9 | (0.64, 0.35) | |

As is understood from Table 1, the blue-emitting organic electroluminescence device of Example 1 is much more excellent in driving voltage, luminous efficiency, chromatic purity and lifetime than the blue-emitting organic electroluminescence devices of Comparatives 1 to 4 arranged in the same manner as a conventional device.
In contrast, although the organic electroluminescence device of Comparative 1 exhibits the chromaticity of almost the same level as that of Example 1, the driving voltage required by Comparative 1 is high because its hole injecting layer is CuPc. In addition, since its electron transporting layer is made of an Alq complex whose electron mobility is low, Comparative 1 is inferior in luminous efficiency and lifetime.

The organic electroluminescence device of Comparative 2 requires lower driving voltage than that of Comparative 1 because its hole injecting layer uses the mixture of PEDOT and Nafion™ as in Example 1. However, since its electron transporting layer is an Alq complex whose electron mobility is low, the emitting region in the emitting layer is shifted toward the cathode. Thus, the value of chromaticity y-coordinate of Comparative 2 is large, and luminous efficiency and lifetime of Comparative 2 are inferior.
The organic electroluminescence device of Comparative 3 requires a lower driving voltage than that of Comparative 1 because its electron transporting layer is formed of ET1. However, since its hole injecting layer is CuPc, Comparative 3 exhibits much shorter lifetime.

In the organic electroluminescence device of Comparative 4, the hole injecting layer only contains the mixture of PEDOT and PSS and does not contain Nafion™, Nafion™, which is a perfluorinated polymer, contains a lot of fluorine. Thus, a hole injecting layer containing Nafion™ exhibits lower refractivity. Example 1, where the hole injecting layer containing Nafion™ was used, employs a structure of a high reflectivity layer (emitting layer + hole transporting layer) / a low reflectivity layer (hole injecting layer) / a high reflectivity layer (ITO), thereby increasing optical interference modes and enhancing light-extraction efficiency of blue-emitting wavelength. As a consequence, luminous efficiency is enhanced. On the other hand, Comparative 4, where the hole injecting layer does not contain Nafion™, hardly produces the above effects, thereby exhibiting lower luminous efficiency.

Comparatives 5 and 6 show a difference between the hole injecting layers with and without Nafion™ in a red-emitting organic electroluminescence device. Compared as the luminous efficiency of Comparative 6 that does not contain Nafion™, Comparative 5 containing Nafion™ exhibits merely slightly-improved luminous efficiency. Materials used for the emitting layer and the hole transporting layer (i.e., low-molecular material), which generally exhibits high reflectivity in a blue short-wavelength region, exhibits lower and lower reflectivity as the wavelength becomes longer than the blue region. The transparent conductive material used for anode exhibits a similar tendency. On the other hand, reflectivity of polymer materials for hole injecting used in Example 1 and Comparatives 2 to 6 is less dependant on the wavelength. Accordingly, a reflectivity difference between the emitting layer, the hole transporting layer and ITO and the hole injecting layer in the red-emitting wavelength region is smaller than the reflectivity difference in the blue-emitting wavelength region, such that the light-extraction efficiency is less improved. Thus, the presence of Nafion™ is less effective on such a red-emitting device.

INDUSTRIAL APPLICABILITY

This invention can be used as an organic electroluminescence device containing mixed color for a display.

## Claims

1. An organic electroluminescence device, comprising an anode, a hole injecting layer, an emitting layer, an electron transporting layer and a cathode in this order, wherein
the hole injecting layer comprises: substituted or unsubstituted poly(alkylene dioxythiophene); and a fluorine-containing colloid-forming polymer acid, and
the electron transporting layer comprises a compound having electron mobility of 1.0 x $10^{-4}cm^2/Vs$ or more at an electric field intensity of 2.5 x $10^5V/cm$.

2. The organic electroluminescence device according to Claim 1, wherein the electron transporting layer comprises a nitrogen-containing heterocycle derivative represented by a formula (1) as follows,

$$HAr\text{-}L\text{-}Ar^1Ar^2 \qquad (1)$$

(where: HAr represents a substituted or unsubstituted nitrogen-containing heterocycle group having 3 to 40 carbon atoms;
L represents a single bond, a substituted or unsubstituted arylene group having 6 to 60 carbon atoms, a substituted or unsubstituted heteroarylene group having 3 to 60 carbon atoms, or a substituted or unsubstituted fluorenylene group;
$Ar^1$ represents a substituted or unsubstituted divalent aromatic hydrocarbon group having 6 to 60 carbon atoms; and $Ar^2$ represents a substituted or unsubstituted aryl group having 3 to 60 carbon atoms.)

3. The organic electroluminescence device according to Claim 1 or 2, wherein
the emitting layer comprises a host and a dopant, and
the host is formed of a material having a molecular weight of 4000 or less.

4. The organic electroluminescence device according to Claim 3, wherein the host comprises a fused-ring compound having at least three rings.

5. The organic electroluminescence device according to Claim 4, wherein the fused-ring compound having at least three rings is an anthracene derivative.

6. The organic electroluminescence device according to Claim 5, wherein the anthracene derivative is represented by a formula (2) as follows,

[Formula 1]

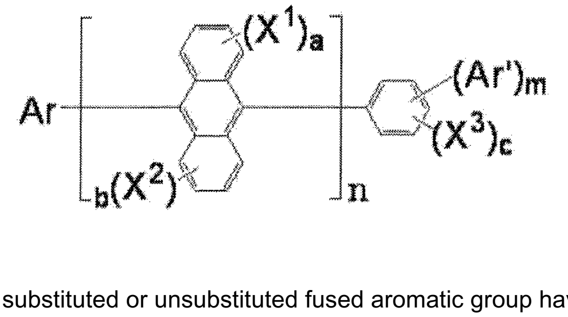

(2)

(where: Ar represents a substituted or unsubstituted fused aromatic group having 10 to 50 carbon atoms forming the aromatic ring;
Ar' represents a substituted or unsubstituted aromatic group having 6 to 50 carbon atoms forming the aromatic ring;
$X^1$ to $X^3$ each represent a substituted or unsubstituted aromatic group having 6 to 50 carbon atoms forming the aromatic ring, a substituted or unsubstituted aromatic heterocyclic group having 5 to 50, a substituted or unsubstituted alkyl group having 1 to 50 carbon atoms, a substituted or unsubstituted alkoxy group having 1 to 50 carbon

atoms, a substituted or unsubstituted aralkyl group having 6 to 50 carbon atoms, a substituted or unsubstituted aryloxy group having 5 to 50 carbon atoms, a substituted or unsubstituted arylthio group having 5 to 50 carbon atoms, a substituted or unsubstituted alkoxycarbonyl group having 1 to 50 carbon atoms, a carboxyl group, a halogen group, a cyano group, a nitro group and a hydroxyl group;

a, b and c are each an integer in a range of 0 to 4, a plurality of $X^1$ being mutually the same or different when a is 2 or more, a plurality of $X^2$ being mutually the same or different when b is 2 or more, a plurality of $X^3$ being mutually the same or different when c is 2 or more; and

n is an integer in a range of 1 to 3 while m is 0 or 1, a plurality of such structures shown in the brackets [ ] as represented by a formula below being mutually the same or different when n is 2 or more.)

[Formula 2]

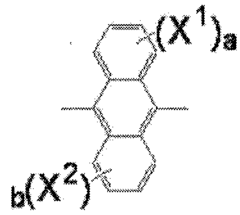

7. The organic electroluminescence device according to Claim 5, wherein the anthracene derivative is an asymmetric monoanthracene derivative represented by a formula (3) as follows,

[Formula 3]

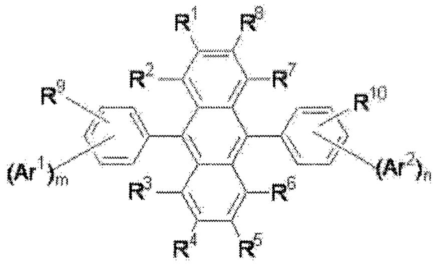

(3)

(where: $Ar^1$ and $Ar^2$ are each a substituted or unsubstituted aromatic ring group having 6 to 50 carbon atoms forming the aromatic ring while m and n are each an integer in a range of 1 to 4, $Ar^1$ and $Ar^2$ being mutually different when: m and n are both equal to 1; and positions at which $Ar^1$ and $Ar^2$ are respectively bonded to benzene rings are symmetric, m and n being mutually different when m or n is an integer in a range of 2 to 4; and

$R^1$ to $R^{10}$ are each a hydrogen atom, a substituted or unsubstituted aromatic ring group having 6 to 50 carbon atoms forming the aromatic ring, a substituted or unsubstituted aromatic heterocycle group having 5 to 50 atoms forming the aromatic ring, a substituted or unsubstituted alkyl group having 1 to 50 carbon atoms, a substituted or unsubstituted cycloalkyl group, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 atoms forming the aromatic ring, a substituted or unsubstituted arylthio group having 5 to 50 atoms forming the aromatic ring, a substituted or unsubstituted alkoxycarbonyl group having 1 to 50 carbon atoms, substituted or unsubstituted silyl group, a carboxyl group, a halogen atom, a cyano group, a nitro group and a hydroxy group.)

8. The organic electroluminescence device according to Claim 5, wherein the anthracene derivative is represented by a formula (4) as follows,

[Formula 4]

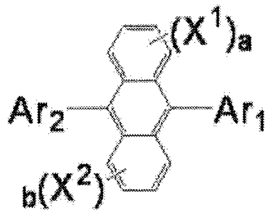

(4)

(where: at least either one of $Ar^1$ and $Ar^2$ is a substituent having a substituted or unsubstituted fused ring group with 10 to 30 carbon atoms forming the aromatic ring;
$X^1$ and $X^2$ are each a substituted or unsubstituted aromatic group having 6 to 50 carbon atoms forming the aromatic ring, a substituted or unsubstituted aromatic heterocycle group having 5 to 50, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 carbon atoms, a substituted or unsubstituted arylthio group having 5 to 50 carbon atoms, a substituted or unsubstituted alkoxycarbonyl group having 1 to 50 carbon atoms, a carboxyl group, a halogen group, a cyano group, a nitro group and hydroxyl group; and
a and b are each an integer in a range of 0 to 4, a plurality of $X^1$ being mutually the same or different when a is 2 or more, a plurality of $X^2$ being mutually the same or different when b is 2 or more.)

**9.** The organic electroluminescence device according to any one of Claims 1 to 8, wherein the substituted or unsubstituted poly(alkylene dioxythiophene) is poly(3,4-ethylenedioxithiophene).

**10.** The organic electroluminescence device according to any one of Claims 1 to 9, wherein the fluorine-containing colloid-forming polymer acid is selected from a group consisting of a fluorine-containing polymer sulfonic acid, a fluorine-containing polymer carboxylic acid, a fluorine-containing polymer phosphoric acid, a fluorine-containing polymer acrylic acid and a mixture of the acids.

**11.** The organic electroluminescence device according to any one of Claims 1 to 10, wherein the fluorine-containing colloid-forming polymer acid is a perfluorinated polymer sulfonic acid.

## INTERNATIONAL SEARCH REPORT

International application No.
PCT/JP2008/052873

A. CLASSIFICATION OF SUBJECT MATTER
*H01L51/50*(2006.01)i

According to International Patent Classification (IPC) or to both national classification and IPC

B. FIELDS SEARCHED

Minimum documentation searched (classification system followed by classification symbols)
H01L51/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2005-232452 A (H.C. Starck GmbH),<br>02 September, 2005 (02.09.05),<br>Full text<br>& US 2005/0202274 A1 & US 2005/0175861 A1<br>& EP 1564250 A1 & EP 1564251 A1<br>& DE 102004006583 A & DE 102004010811 A<br>& CA 2496173 A & CA 2496286 A<br>& IL 166738 D & IL 166739 D<br>& KR10-2006-0041801 A & KR 10-2006-0041802 A<br>& CN 1654506 A & CN 1654542 A | 1-11 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 01 April, 2008 (01.04.08) | 08 April, 2008 (08.04.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2008/052873

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2005-226072 A (H.C. Starck GmbH), 25 August, 2005 (25.08.05), Full text & US 2005/0202274 A1 & US 2005/0175861 A1 & EP 1564250 A1 & EP 1564251 A1 & DE 102004006583 A & CA 2496173 A & CA 2496286 A & IL 166738 D & IL 166739 D & KR 10-2006-0041801A & KR 10-2006-0041802 A & CN 1654506 A & CN 1654542 A | 1-11 |
| Y | JP 2003-229277 A (Matsushita Electric Industrial Co., Ltd.), 15 August, 2003 (15.08.03), Par. Nos. [0009] to [0011] (Family: none) | 1-11 |
| Y | WO 2006/046441 A1 (Idemitsu Kosan Co., Ltd.), 04 May, 2006 (04.05.06), Par. Nos. [0060] to [0065], [0082] to [0098] & EP 1806334 A1 | 1-11 |
| Y | JP 2004-2297 A (Idemitsu Kosan Co., Ltd.), 08 January, 2004 (08.01.04), Full text & US 2006/0154105 A1 & EP 1582516 A1 & WO 2004/063159 A1 & KR10-2005-0091080 A & CN 1751024 A | 1-11 |
| Y | WO 2005/042667 A1 (EASTMAN KODAK CO.), 12 May, 2005 (12.05.05), Full text & JP 2007-510294 A & US 2005/0089715 A1 & EP 1680480 A & KR 10-2006-0096055 A & CN 1871324 A | 3-8 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000091081 A
- JP 2003297582 A
- JP 2005232452 A
- JP 2006500461 A
- JP 2006500463 A
- JP 2006313931 A
- WO 2004080975 A
- JP 57051781 A
- US 3282875 A
- US 4358545 A
- US 4940525 A
- US 4433082 A
- US 6150426 A
- WO 03006537 A